# EUROPÄISCHE PATENTANMELDUNG

(11) **EP 4 411 404 A1**
(43) Veröffentlichungstag der Anmeldung: **07.08.2024**
(21) Anmeldenummer: 24152645.8
(22) Anmeldetag: 18.01.2024
(51) Int. Cl.: G01R 33/00

(54) **VERFAHREN ZUR FUNKTIONSDIAGNOSE UND/ODER FEHLERDIAGNOSE VON MAGNETFELDSENSOREN IN DIFFERENTIELLEN MAGNETFELDMESSSYSTEMEN MITTELS EINER MAGNETFELDSENSOR-DIAGNOSEEINHEIT**

(30) Priorität: 31.01.2023 DE 102023200773; 14.06.2023 DE 102023205513
(71) Anmelder: Robert Bosch GmbH, 70442 Stuttgart (DE)
(72) Erfinder: ZEGOWITZ, Michael, 72108 Rottenburg Am Neckar (DE); BREITFELD, Andreas, 70567 Stuttgart (DE); RALL, Astrid, 74211 Leingarten (DE); WIENSS, Andreas, 72800 Eningen Unter Achalm (DE); SCHICKLE, Sven, 72070 Tuebingen (DE)

(57) **Zusammenfassung**

Die vorliegende Erfindung betrifft ein Verfahren (100) zur, insbesondere messbetriebsunterbrechungsfreien und diagnosestromdrifttoleranten, Funktionsdiagnose und/oder Fehlerdiagnose von Magnetfeldsensoren in einem differentiellen Magnetfeldmesssystem mittels einer Magnetfeldsensor-Diagnoseeinheit (10), aufweisend die Schritte:
- Erzeugen (S1) eines ersten Signals mit einem ersten Wert in einen Signalleiter (14),
- Erfassen (S2) jeweils eines ersten Messsignals mittels einer ersten Messung durch einen ersten Magnetfeldsensor (20) mit einer ersten Messachse (22) und durch einen zweiten Magnetfeldsensor (26) mit einer zweiten Messachse (28), wobei die erste Messachse (22) und die zweite Messachse (28) im Wesentlichen eine gleiche relative Lage (30) aufweisen,
- Erzeugen (S3) eines zweiten Signals mit einem zweiten Wert in den Signalleiter (14),
- Erfassen (S4) jeweils eines zweiten Messsignals mittels einer zweiten Messung durch den ersten Magnetfeldsensor (20) und durch den zweiten Magnetfeldsensor (26),
- Bilden (S5) einer ersten Differenz zwischen dem zweiten Messsignal und dem ersten Messsignal des ersten Magnetfeldsensors (20) und Bilden (S9) einer zweiten Differenz zwischen dem zweiten Messsignal und dem ersten Messsignal des zweiten Magnetfeldsensors (26),
- Ermitteln (S6) der zumindest einen Eigenschaft des ersten Magnetfeldsensors (20) und/oder des zweiten Magnetfeldsensors (26) basierend auf der ersten Differenz und der zweiten Differenz.

## Beschreibung

### Stand der Technik

Die vorliegende Erfindung betrifft ein Verfahren zur, insbesondere messbetriebsunterbrechungsfreien und diagnosestromdrifttoleranten, Funktionsdiagnose von Magnetfeldsensoren in differentiellen Magnetfeldmesssystemen mittels einer Magnetfeldsensor-Diagnoseeinheit, eine Magnetfeldsensor-Diagnoseeinheit, eine Antriebseinheit für ein Fahrzeug sowie die Verwendung einer Magnetfeldsensor-Diagnoseeinheit zur messbetriebsunterbrechungsfreien und diagnosestromdrifttoleranten Funktionsdiagnose von Magnetfeldsensoren in einem differentiellen Magnetfeldmesssystem.

Derzeit bestehen eine Vielzahl an unterschiedlichen Lösungen zur Vermessung von Magnetfeldern im Fahrzeugbereich bzw. E-Bike-Bereich. Durch die zunehmende Anzahl an zu überwachenden Kenngrößen im Fahrzeugbereich insbesondere bei elektronisch angetriebenen Fahrrädern steigt kontinuierlich der Bedarf an innovativen und robusten Messverfahren.

Die stetige Gewichtsreduzierung im Fahrradbereich zur Effizienzsteigerung sowie der zunehmende Wettbewerb sorgt für Kostendruck, so dass günstigere und effizientere Komponenten für Fahrzeuge, insbesondere Fahrräder, stärker nachgefragt werden.

### Offenbarung der Erfindung

Das erfindungsgemäße Verfahren zur, insbesondere messbetriebsunterbrechungsfreien und diagnosestromdrifttoleranten, Funktionsdiagnose von Magnetfeldsensoren in einem differentiellen Magnetfeldmesssystem mittels einer Magnetfeldsensor-Diagnoseeinheit mit den Merkmalen des Anspruchs 1 weist gegenüber dem Bekannten den Vorteil auf, dass die Funktionsdiagnose der Magnetfeldsensoren während dem Messbetrieb ohne diesen zu unterbrechen auch dann noch erfolgen kann, wenn der für die Funktionsdiagnose der Magnetfeldsensoren zu erzeugende Diagnosestrom nicht oder nicht exakt bestimmt werden kann oder ein Temperaturdrift auftritt. Die oft auftretende Temperaturdrift kann ein gewisser Drift des Diagnosestroms aus einer Treibereinrichtung beispielsweise über der Temperatur sein und lässt sich mit dem Diagnosestrom nur schwer vorherbestimmen. Zudem bedarf es einer hochpräzisen Treibereinrichtung um den Drift und die durch ihn entstehenden Fehler weitestgehend zu reduzieren. Weitere Vorteile des erfindungsgemäßen Verfahrens können damit die Einsparung von kostenintensiven hochpräzisen Treibereinrichtungen sein, da die Bestimmung des Diagnosestroms wie hier vorgeschlagen optional durchgeführt werden kann und somit eine hochpräzise Strommesseinrichtung eingespart werden kann, da der Diagnosestrom wie hier vorgeschlagen nicht exakt erfasst werden sollte, während dennoch die Funktionsdiagnose der Magnetfeldsensoren während dem Messbetrieb erfolgen kann. Ferner kann mittels der gleichen Messachsen der Magnetfeldsensoren mit einem Signal für alle Magnetfeldsensoren geprüft werden kann, ob einer der Magnetfeldsensor noch funktioniert. Ferner kann dabei die Diagnose über die Magnetfeldsensoren während des Messbetriebs vollzogen werden, ohne dabei zusätzliche Hardware zu benötigen. Ferner ist es dabei möglich, aufgrund des relativen Abgleiches zwischen mehreren Magnetfeldsensoren magnetische Störfelder zu kompensieren. Besonders vorteilhaft ist, dass mittels eines einzelnen Signalgebers und eines einzelnen Signalleiters mehrere Magnetfeldsensoren überprüft werden können, was besonders kostengünstig sein kann.

Dies wird erfindungsgemäß dadurch erreicht, dass das Verfahren zur, insbesondere messbetriebsunterbrechungsfreien und diagnosestromdrifttoleranten, Funktionsdiagnose und/oder Fehlerdiagnose von Magnetfeldsensoren in einem differentiellen Magnetfeldmesssystem mittels einer Magnetfeldsensor-Diagnoseeinheit folgende Schritte aufweist:
- Erzeugen eines ersten Signals mit einem ersten Wert in einen Signalleiter,
- Erfassen jeweils eines ersten Messsignals mittels einer ersten Messung durch einen ersten Magnetfeldsensor mit einer ersten Messachse und durch einen zweiten Magnetfeldsensor mit einer zweiten Messachse, wobei die erste Messachse und die zweite Messachse im Wesentlichen eine gleiche relative Lage aufweisen,
- Erzeugen eines zweiten Signals mit einem zweiten Wert in den Signalleiter,
- Erfassen jeweils eines zweiten Messsignals mittels einer zweiten Messung durch den ersten Magnetfeldsensor und durch den zweiten Magnetfeldsensor,
- Bilden einer ersten Differenz zwischen dem zweiten Messsignal und dem ersten Messsignal des ersten Magnetfeldsensors und Bilden einer zweiten Differenz zwischen dem zweiten Messsignal und dem ersten Messsignal des zweiten Magnetfeldsensors,
- Ermitteln der zumindest einen Eigenschaft des ersten Magnetfeldsensors und/oder des zweiten Magnetfeldsensors basierend auf der ersten Differenz und der zweiten Differenz.

In anderen Worten ist mittels eines ersten und eines zweiten Signals in einem einzelnen Signalleiter, welcher durch zwei Magnetfeldsensoren überwacht wird, feststellbar, ob die beiden Magnetfeldsensoren und/oder nur einer davon, funktionieren. Bei dem ersten Signal und dem zweiten Signal handelt es sich insbesondere um ein Diagnosestromsignal. Insbesondere sind der erste Wert des ersten Signals und der zweite Wert des zweiten Signals verschieden voneinander. Bei dem ersten Messsignal und dem zweiten Messsignal handelt es sich insbesondere um ein Summensignal, bestehend aus Messmagnetfeld und Diagnosemagnetfeld. Es handelt sich also bei dem jeweiligen Erfassen eines Messsignals mittels einer Messung durch den jeweiligen Magnetfeldsensor um die Messung der Summensignale aus dem jeweiligen Diagnosemagnetfeldsignal und dem Messmagnetfeldsignal. Darin liegt ein weiterer Vorteil des erfindungsgemäßen Verfahrens. Die Erfassung von Messgrößen mittels der Magnetfeldsensoren wie auch die Bestimmung der Eigenschaften der Magnetfeldsensoren können gleichzeitig stattfinden, sodass die Erfassung der Messgrößen für die Funktionsdiagnose nicht unterbrochen werden muss. Beispielsweise kann der erste Magnetfeldsensor und/oder oder der zweite Magnetfeldsensor ein Summensignal erfassen, insbesondere während der ersten Messung und der zweiten Messung.

Bevorzugt kann das Verfahren dazu eingerichtet sein, eine Funktionsdiagnose und/oder Fehlerdiagnose eines Magnetfeldsensors zu ermöglichen, wobei das Verfahren ferner insbesondere dazu eingerichtet ist, eine messbetriebsunterbrechungsfreie und diagnosestromdrifttolerante Diagnose von Magnetfeldsensoren in Differential-Mode-Auswertung durchzuführen. Dabei kann eine Eigenschaft des Magnetfeldsensors beispielsweise ein Defekt des Magnetfeldsensors, eine Fehlfunktion, eine Drift, eine Betriebsstörung, eine Abweichung, ein Fehler, welcher durch eine Drift als solcher fälschlicherweise identifiziert wurde und/oder eine abnormale Funktionsweise des Magnetfeldsensors sein. Bevorzugt ist ein Signalgeber wie beispielsweise ein Single-Stimuli-Generator, eine einfach steuerbare geregelte Spannungsquelle und/oder eine steuerbare geregelte Stromquelle oder Stromsenke derart an einem Signalleiter angeordnet, dass dieser zumindest ein Signal bevorzugt eine Vielzahl an Signalen in den Signalleiter leiten kann. Bevorzugt weist der Signalleiter eine im Wesentlichen gleiche Orientierung zu allen Magnetfeldsensoren auf, so dass sowohl das erste Signal als auch das zweite Signal mittels der Magnetfeldsensoren erfasst werden kann. Dabei kann das Signal, insbesondere das Diagnosestromsignal, ein Diagnosemagnetfeld erzeugen, welches mittels eines Magnetfeldsensors erfasst werden kann. Dabei kann das Diagnosestromsignal derart gewählt werden, dass ein gleichausgerichtetes Diagnosemagnetfeld für jeden Magnetfeldsensor erzeugt werden kann, insbesondere mit gleicher Amplitude. Ferner kann mittels des Signals bzw. eine Vielzahl von Signalen ein Magnetfeld ausgebildet werden, welches einen pulsförmigen Amplitudenverlauf aufweist. Dabei kann der pulsförmige Amplitudenverlauf den Vorteil aufweisen, dass ein hohen bzw. starker Anstieg der Flankensteilheit besonders einfach detektierbar ist, insbesondere wenn es sich um eine Hall-Sonde handelt. Das erste Signal, das zweite Signal sowie eine Vielzahl von Signalen können insbesondere als ein Diagnosestrompuls ausgebildet sein, so dass diese in einem Kennwertverlauf der Magnetfeldsensoren deutlich zu erkennen sind. Ferner weisen sowohl der erste Magnetfeldsensor als auch der zweite Magnetfeldsensor je eine Messachse mit im Wesentlichen gleicher relativer Lage auf. Dabei kann die relative Lage der Messachsen insbesondere eine Orientierung und/oder Ausrichtung der Messachsen im dreidimensionalen Raum sein. Darüber hinaus kann eine Differenz zwischen der ersten Messung und der zweiten Messung gebildet werden. Beispielsweise wird ein erstes Steuersignal auf einen ersten Wert gesetzt. Im Anschluss kann das erste Signal in den Signalleiter gegeben werden. Das erste Signal wird mittels der Magnetfeldsensoren vermessen. Weiter bevorzugt kann das Steuersignal auf einen zweiten Wert gesetzt werden. Der Signalgeber leitet das zweite Signal mit dem zweiten Wert in den Signalleiter. Das zweite Signal kann mittels einer zweiten Messung durch die Magnetfeldsensoren erfasst werden. Basierend auf der ersten Messung und der zweiten Messung kann eine Differenz zwischen den beiden Signalen, welche durch die Magnetfeldsensoren erfasst wurden, gebildet werden, um anhand dieser Differenz eine Eigenschaft des ersten und/oder zweiten Magnetfeldsensors zu ermitteln. Dabei können die Werte der ersten Messung und der zweiten Messung von einem Offset befreit sein. Das Offset der einzelnen Magnetfeldsensoren kann einmalig für eine Messanordnung bestimmt werden und für die Lebensdauer der Messanordnung verwendet werden. Bspw. kann das Offset durch eine Zweitpunktkalibrierung erfolgen, wobei der erste Punkt bei einem Drehmoment von 0 Nm erfolgen kann und der zweite Punkt bei 80 Nm Drehmoment eines elektrischen Antriebs eines Fahrrads.

Das erfindungsgemäße Verfahren zur bevorzugten Ausführung mit der erfindungsgemäßen Magnetfeldsensor-Diagnoseeinheit umfasst insbesondere das Erzeugen von Diagnosestromsignalen in einem Signalleiter; das Erfassen von Messsignalen aus Diagnosemagnetfeld und Messmagnetfeld durch die Magnetfeldsensoren; das laufende Bilden eines differentiellen Messmagnetfeldsignals, welches vom Diagnosemagnetfeldsignal bereinigt ist und als Messgröße des differentiellen Magnetfeldmesssystems dient. Die Bereinigung erfolgt durch Differenzbildung zwischen den Messsignalen der Magnetfeldsensoren einer jeden Messung, wodurch Diagnosemagnetfeldsignal eliminiert werden. Ferner sind umfasst das Bilden von Differenzen zwischen aufeinanderfolgenden Messsignal-Messungen, welche dem jeweiligen Magnetfeldsensor zugehörig sind, während zumindest zwei verschiedenen Diagnosestromhöhen; sowie hierauf basierend das Detektieren von Fehlfunktionen der Magnetfeldsensoren mit den Vorteilen, dass neben der Funktionsdiagnose der differentielle Messbetrieb ununterbrochen und ungestört bleibt, auch bei Drifts des Diagnosestroms.

Die Unteransprüche zeigen bevorzugte Weiterbildungen der Erfindung.

Weiter bevorzugt ist das Verfahren dazu eingerichtet bei dem Erzeugen des ersten Signals und des zweiten Signals nur einen einzelnen Strom und/oder Stromimpuls in den Signalleiter zu erzeugen und in einen Signalleiter zu leiten.

In einer Ausgestaltung des Verfahrens werden folgende Schritte ausgeführt: Bilden eines differentiellen Messmagnetfeldsignals als ersten Wert der Messgröße des Magnetfeldmesssystems durch Differenzbildung zwischen dem ersten Messsignal des ersten Magnetfeldsensors der ersten Messung und dem ersten Messsignal des zweiten Magnetfeldsensors der ersten Messung; sowie Bilden eines differentiellen Messmagnetfeldsignals als Folgewert der Messgröße des Magnetfeldmesssystems durch Differenzbildung zwischen dem zweiten Messsignal des ersten Magnetfeldsensors der zweiten Messung und dem zweiten Messsignal des zweiten Magnetfeldsensors der zweiten Messung. Dabei wird ein vom ersten Diagnosemagnetfeldsignal bzw. vom zweiten Diagnosemagnetfeldsignal bereinigtes differentielles Messmagnetfeldsignal gebildet.

Vorzugsweise umfasst das Ermitteln der zumindest einen Eigenschaft den Schritt: Vergleichen der ersten Differenz und der zweiten Differenz mit einem vorbestimmten Schwellwert, um die Eigenschaft des ersten Magnetfeldsensors und/oder des zweiten Magnetfeldsensors zu ermitteln. Ein Vorteil dieser Ausführungsform kann sein, dass mithilfe des Vergleiches anhand eines vordefinierten Schwellwertes eine einfache Möglichkeit besteht, zu prüfen, ob der Magnetfeldsensor noch in einem vorgesehenen Bereich arbeitet oder nicht. In anderen Worten bildet die Differenz einen ersten Wert, der mit einem zweiten, insbesondere einen Schwellwert verglichen werden kann, um zu prüfen, ob der erste Wert der Differenz einen vorbestimmten Schwellwert über- oder unterschreitet. Dabei kann der Schwellwert für eine Messwertanordnung individuell festgelegt werden.

Beispielsweise kann der Schwellwert 35 µT betragen. Dabei kann der Vergleich mit unterschiedlichen Schwellwerten wiederholt werden. Beispielsweise umfasst der vorbestimmte Schwellwert eine obere Grenze und eine untere Grenze. Somit kann mittels des Vergleichens der ersten Differenz mit dem vorbestimmten Schwellwert ermittelt werden, ob die Differenz in einem Bereich liegt. Dabei kann die obere Grenze zum Beispiel +35 µT betragen und die untere Grenze -35 µT.

Ferner können die Vergleiche mit einem Schwellwert die Detektion einer Fehlfunktion je Magnetfeldsensor mit Abweichung der Differenz ausschließlich nach unten oder ausschließlich nach oben ermöglichen. Zudem können Vergleiche mit zwei Schwellwerten die Detektion einer Fehlfunktion je Magnetfeldsensor mit Abweichung der Differenz sowohl nach unten als auch und oben ermöglichen.

Weiter bevorzugt weist das Ermitteln der zumindest einen Eigenschaft die Schritte auf: Ermitteln und/oder Empfangen einer Kalibrierung eines Diagnosemagnetfelds des ersten Magnetfeldsensors und/oder des zweiten Magnetfeldsensors und Vergleichen der ersten Differenz und der zweiten Differenz mit zumindest einem vorbestimmten Schwellwert basierend auf der Kalibrierung des Diagnosemagnetfelds des ersten Magnetfeldsensors und/oder des zweiten Magnetfeldsensors, um die Eigenschaft des ersten Magnetfeldsensors und/oder des zweiten Magnetfeldsensors zu ermitteln. Dabei umfasst die Kalibrierung des Diagnosemagnetfelds des ersten Magnetfeldsensors insbesondere die Kalibrierung des ersten differentiellen Diagnosemagnetfelds im ersten Magnetfeldsensor, zugehörig zu einem differentiellen Soll-Diagnosestromsignal des erzeugten differentiellen Diagnosestromsignals aus einem zweitem Diagnosestromsignal mit dem zweiten Wert und einem erstem Diagnosestromsignal mit dem ersten Wert. Dabei umfasst ferner die Kalibrierung des zweiten Diagnosemagnetfelds des zweiten Magnetfeldsensors die Kalibrierung eines zweiten differentiellen Diagnosemagnetfelds im zweiten Magnetfeldsensor, zugehörig zu dem differentiellen Soll-Diagnosestromsignal des erzeugten differentiellen Diagnosestromsignals aus zweitem Diagnosestromsignal mit dem zweiten Wert und erstem Diagnosestromsignal mit dem ersten Wert. Es können weitere Magnetfeldsensoren, insbesondere ein dritter Magnetfeldsensor, vorhanden sein. Eine Kalibrierung eines Diagnosemagnetfelds des dritten Magnetfeldsensors erfolgt entsprechend der Kalibrierung des Diagnosemagnetfelds des ersten und zweiten Magnetfeldsensors.

Ein Vorteil dieser Ausführungsform ist, dass der vorbestimmte Schwellwert deutlich kleiner gewählt werden kann, und somit eine Detektionsgenauigkeit deutlich erhöht werden kann, da mittels der Kalibrierung eine eventuelle Abweichung der Signale, insbesondere der Diagnosestromsignale durch Toleranzen beispielsweise des Stromtreibers oder ähnlichem mit in die Berechnung einbezogen werden kann. Damit kann zudem die tolerierbare Drift des Diagnosestroms beispielsweise über Temperatur weiter vergrößert werden. Ferner kann eine Ermittlung der ersten Kalibrierung zumindest ein einmaliges vorgelagertes Ermitteln des ersten Kalibrierwerts aus der ersten Differenz, welche für die Kalibrierung einmalig exklusiv zu erzeugen und zu ermitteln ist, bezüglich des ersten Magnetfeldsensors umfassen. Ferner kann ein einmaliges vorgelagertes Ermitteln des zweiten Kalibrierwerts aus der zweiten Differenz, welche für die Kalibrierung einmalig, gemeinsam mit der Erzeugung der ersten Differenz, exklusiv zu erzeugen und zu ermitteln ist, bezüglich des zweiten Magnetfeldsensors erfolgen.

Dabei kann die Kalibrierung insbesondere während und/oder unmittelbar nach eines Fertigungs- und/oder Montageverfahrens des Magnetfeldsensors oder ähnlichem erfasst werden und in den Magnetfeldsensor und/oder in eine Steuereinheit, wie bspw. eine ECU, eingespeichert werden, um diesen bei der Berechnung zu berücksichtigen. Dabei kann die Kalibrierung insbesondere mittels einer Zweipunktkalibrierung erfolgen. Dabei können die zwei Punkte der Kalibrierung insbesondere den während der Detektion der zumindest einen Fehlfunktion angefahrenen Punkte entsprechen. Dabei kann der erste Punkt insbesondere dem Diagnosestromsignal von null entsprechend und der zweite Punkt einem Diagnosestromsignal ungleich null entsprechen. Bspw. kann der vorbestimmte Schwellwert bei dem Vorliegen einer Kalibrierung 20 µT betragen. Ferner kann der vorbestimmte Schwellwert eine obere Grenze und eine untere Grenze umfassen. Somit kann die jeweilige Differenz gegen die untere Grenze und die obere Grenze verglichen werden, wenn die ermittelten Werte des Magnetfeldsensors mittels der Kalibrierung korrigiert wurden.

Vorzugsweise umfasst das Verfahren ferner die Schritte: Erfassen des ersten Messsignals mittels der ersten Messung durch einen dritten Magnetfeldsensor mit einer dritten Messachse, wobei die erste Messachse, die zweite Messachse und die dritte Messachse im Wesentlichen die gleiche relative Lage aufweisen, sowie Erfassen des zweiten Messsignals mittels der zweiten Messung durch den dritten Magnetfeldsensor. Danach Bilden einer dritten Differenz zwischen dem zweiten Messsignal und dem ersten Messsignal des dritten Magnetfeldsensors und Ermitteln zumindest einer Eigenschaft des ersten Magnetfeldsensors, des zweiten Magnetfeldsensors und/oder des dritten Magnetfeldsensors basierend auf einem Vergleich der ersten Differenz, der zweiten Differenz und/oder der dritten Differenz. Ein Vorteil dieser Ausführungsform ist, dass anhand des Vergleiches zwischen den unterschiedlichen Differenzen eine zuverlässigere Möglichkeit besteht, die Funktion des Magnetfeldsensors zu überprüfen. Dies ist besonders bei hochdynamischen AC-Störfeldern vorteilhaft, da durch das Monitoring der differentiellen Größe die hochdynamischen AC-Störfelder vorab eliminiert werden können.

In einer Ausgestaltung des Verfahrens weist das Ermitteln der zumindest einen Eigenschaft ferner die Schritte auf: Bilden einer ersten Vergleichsdifferenz zwischen der ersten Differenz und der zweiten Differenz sowie Vergleichen der ersten Vergleichsdifferenz mit zumindest einem vorbestimmten Grenzwert, um einen ersten Zustand zu ermitteln; Bilden einer zweiten Vergleichsdifferenz zwischen der zweiten Differenz und der dritten Differenz sowie Vergleichen der zweiten Vergleichsdifferenz mit zumindest einem weiteren vorbestimmten Grenzwert, um einen zweiten Zustand zu ermitteln. Danach Detektieren einer Eigenschaft, insbesondere einer Fehlfunktion, des ersten Magnetfeldsensors, wenn der erste Zustand vorliegt, sowie Detektieren einer Eigenschaft, insbesondere Fehlfunktion, des zweiten Magnetfeldsensors, wenn der erste Zustand und der zweite Zustand vorliegen, und/oder Detektieren einer Eigenschaft, insbesondere Fehlfunktion, des dritten Magnetfeldsensors, wenn der zweite Zustand vorliegt. Unter dem Begriff Zustand ist eine Situation zu verstehen, in welcher der erste Magnetfeldsensor oder der zweite Magnetfeldsensor oder der dritte Magnetfeldsensor als defekt bzw. mit einer Fehlfunktion detektiert wird.

Ein Vorteil dieser Ausführungsform ist, dass mithilfe der Zustände genau ermittelt werden kann, welcher Magnetfeldsensor von einer Gruppe von Magnetfeldsensoren defekt ist. Somit lässt sich mithilfe der Interpretation der Diagnosen einzelne Sensoren bzw. deren Funktionsfähigkeit überprüfen. Dabei kann der vorbestimmte Grenzwert insbesondere 30 µT betragen. Die erste Vergleichsdifferenz kann dabei insbesondere mittels einer Subtraktion zwischen der ersten Differenz und der zweiten Differenz ermittelt werden. Weiter bevorzugt kann die zweite Vergleichsdifferenz mittels einer Subtraktion zwischen der zweiten Differenz und der dritten Differenz ermittelt werden.

Dabei weist das Bilden der ersten Vergleichsdifferenz vorzugsweise ferner die Schritte auf: Bereinigen der ersten Differenz mit einer ersten Kalibrierung des Diagnosemagnetfelds des ersten Magnetfeldsensors; und Bereinigen der zweiten Differenz mit einer zweiten Kalibrierung des Diagnosemagnetfelds des zweiten Magnetfeldsensors. Außerdem weist das Bilden der zweiten Vergleichsdifferenz vorzugweise die Schritte auf: Bereinigen der zweiten Differenz mit einer zweiten Kalibrierung des Diagnosemagnetfelds des zweiten Magnetfeldsensors; und Bereinigen der dritten Differenz mit einer dritten Kalibrierung des Diagnosemagnetfelds des dritten Magnetfeldsensors.

Diese Ausführungsvariante hat gegenüber der Ausführung ohne Kalibrierung den Vorteil, dass etwaig verbliebene Resttoleranzen aus der Fertigung der Magnetfeldsensoren und der Fertigung bzw. der Montage der Magnetfeldsensor-Diagnoseeinheit mit den Magnetfeldsensoren eliminiert werden können.

Ein Vorteil dieser Ausführungsform ist, dass mittels der Kalibrierung eine Feinjustage der Monitoring-Fenster erfolgen kann, so dass mit einer höheren Wahrscheinlichkeit auf die Funktionsfähigkeit der Magnetfeldsensoren geschlossen werden kann. Ferner kann der vorbestimmte Grenzwert kleiner gewählt werden, wenn eine Kalibrierung vorliegt. Dabei kann der vorbestimmte Grenzwert bei 17 µT liegen. Bspw. kann die Eigenschaft des Magnetfeldsensors anhand der folgenden Formel ermittelt werden:
WENN (Abs ((ΔBₓ₁ - ΔB_{x1,calib}) - (ΔBₓ₂ - ΔBₓ₂,_{calib}) ) > 17µT) {Sensor 1 oder Sensor 2 defekt; E12=12}
WENN (Abs((ΔBₓ₂ - ΔBₓ₂,_{calib}) - (ΔBₓ₃ - ΔB_{x3,calib}) ) > 17µT ) {Sensor 2 oder Sensor 3 defekt; E23=23}
WENN (E12==12 UND E23==23) {Sensor 2 defekt}
SONST WENN (E12==12) {Sensor 1 defekt}
WENN (E23==23) {Sensor 3 defekt}

Dabei kann E12==12 der erste Zustand sein und E23==23 der zweite Zustand sein. ΔBₓ₁ kann dabei die erste Differenz sein. ΔB_{x1,calib} kann die erste Kalibrierung sein. ΔBₓ₂ kann die zweite Differenz sein. ΔBₓ₂,_{calib} kann die zweite Kalibrierung sein. ΔBₓ₃ kann die dritte Differenz sein. ΔB_{x3,calib} kann die dritte Kalibrierung sein. Der vorbestimmte Grenzwert kann dabei 17µT betragen. Sensor 1 kann der erste Magnetfeldsensor sein. Sensor 2 kann der zweite Magnetfeldsensor sein. Sensor 3 kann der dritte Magnetfeldsensor sein. Ferner kann die erste Differenz derart ermittelt werden: ΔBx₁ = b₁ - a₁. Dabei kann b₁ die zweite Messung mit dem ersten Magnetfeldsensor sein. Ferner kann a₁ die erste Messung mit dem ersten Magnetfeldsensor sein. Ferner kann die zweite Differenz derart ermittelt werden: ΔBx₂ = b₂ - a₂. Dabei kann b₂ die zweite Messung mit dem zweiten Magnetfeldsensor sein. Ferner kann a₂ die erste Messung mit dem zweiten Magnetfeldsensor sein. Ferner kann die dritte Differenz derart ermittelt werden: ΔBx₃ = b₃ - a₃. Dabei kann b₃ die zweite Messung mit dem dritten Magnetfeldsensor sein. Ferner kann a₃ die erste Messung mit dem dritten Magnetfeldsensor sein. Bspw. kann das erste Signal einen logischen Wert von 0 aufweisen. Ferner kann das zweite Signal einen logischen Wert von 5 aufweisen. Das erste Signal kann mittels der ersten Messung des ersten Magnetfeldsensors, des zweiten Magnetfeldsensors und des dritten Magnetfeldsensors erfasst werden. Das zweite Signal kann mittels der zweiten Messung des ersten Magnetfeldsensors, des zweiten Magnetfeldsensors und des dritten Magnetfeldsensors erfasst werden.

Vorzugsweise umfasst das Verfahren ferner die Schritte: Vergleichen eines ersten Betrags der ersten Differenz mit einem Minimalwert; Vergleichen eines zweiten Betrags der zweiten Differenz mit dem Minimalwert; und/oder Vergleichen eines dritten Betrags der dritten Differenz mit dem Minimalwert; sowie Ausgeben eines Warnsignals, wenn der erste Betrag, der zweite Betrag und/oder der dritte Betrag den Minimalwert unterschreitet.

Ein Vorteil dieser Ausführungsform ist, dass eventuelles Rauschen des Magnetfeldsensors nicht als Signal gewertet werden kann bzw. der Betrag des Signals insbesondere ersten und/oder des zweiten Signals ausreichend hoch ist, um auf die Funktionsweise des Magnetfeldsensors rückschließen zu können. Zum Beispiel kann der Minimalwert 15 µT betragen.

In einer Ausführungsform weist das Verfahren ferner die Schritte auf: Erzeugen eines dritten Signals mit dem ersten Wert in den Signalleiter; Erfassen jeweils eines dritten Messsignals mittels einer dritten Messung durch den ersten Magnetfeldsensor, durch den zweiten Magnetfeldsensor und durch den dritten Magnetfeldsensor; Bilden jeweils einer ersten Differenzvariablen zwischen dem zweiten Messsignal und dem ersten Messsignal für den ersten Magnetfeldsensor, den zweiten Magnetfeldsensor, und den dritten Magnetfeldsensor; Bilden jeweils einer zweiten Differenzvariablen zwischen dem zweiten Messsignal und dem dritten Messsignal für den ersten Magnetfeldsensor, den zweiten Magnetfeldsensor, und den dritten Magnetfeldsensor; Bilden jeweils eines Differenzvariablenmittelwerts basierend auf einem Differenzvergleich zwischen der ersten Differenzvariablen und der zweiten Differenzvariablen für den ersten Magnetfeldsensor, den zweiten Magnetfeldsensor, und den dritten Magnetfeldsensor; und Ersetzen eines Werts der ersten Differenz, der zweiten Differenz und der dritten Differenz jeweils mit dem Differenzvariablenmittelwert des ersten Magnetfeldsensors, des zweiten Magnetfeldsensors und des dritten Magnetfeldsensors.

Ein Vorteil dieser Ausführungsform ist, dass mittels des Differenzvariablenmittelwerts der Differenzvariablen auch bei hochdynamischen Messmagnetfeldern eine besonders robuste Funktionsdiagnose erreicht werden kann. Insbesondere kann durch Erzeugen eines dritten Signals bzw. Diagnosestromsignals mit wiederholt dem ersten Wert, für jeden der Magnetfeldsensoren eine Differenzvariable aus zwei erfassten bzw. gemessenen Signalen bzw. Summensignalen gebildet werden, sodass je Magnetfeldsensor ein Differenzvariablenmittelwert aus den beiden Differenzvariablen gebildet werden kann. Insbesondere kann durch Erzeugen eines dritten Diagnosestromsignals mit wiederholt dem ersten Wert, je Magnetfeldsensor eine weitere Differenz aus zwei gemessenen Summensignalen gebildet werden, sodass je Magnetfeldsensor eine Mittelwertbildung aus den beiden Differenzen aus den insgesamt drei Summensignalen, basierend auf den insgesamt drei Diagnosestromsignalen, erfolgen kann.

Ein weiterer Aspekt der Erfindung betrifft eine Magnetfeldsensor-Diagnoseeinheit zur messbetriebsunterbrechungsfreien und diagnosestromdrifttoleranten Funktionsdiagnose von Magnetfeldsensoren in einem differentiellen Magnetfeldmesssystem, welche einen Signaltreiber, einen Signalleiter und eine Logikeinheit umfasst, welche dazu eingerichtet ist, eine Signalfolge mit zumindest zwei unterschiedlichen Werten mittels des Signaltreibers zu erzeugen, wobei der Signaltreiber dazu eingerichtet ist, die Signalfolge in den Signalleiter zu leiten. Dabei weist der Signalleiter eine erste Orientierung und eine erste Distanz zu einem ersten Magnetfeldsensor mit einer ersten Messachse auf und eine zweite Orientierung und eine zweite Distanz zu einem zweiten Magnetfeldsensor mit einer zweiten Messachse, wobei die erste Messachse und die zweite Messachse eine im Wesentlichen gleiche relative Lage aufweisen. Dabei sind die erste Orientierung und die erste Distanz und die zweite Orientierung und die zweite Distanz im Wesentlichen gleich. Die Logikeinheit ist dazu eingerichtet, die Signalfolge mittels des ersten Magnetfeldsensors und des zweiten Magnetfeldsensors zu erfassen, um zumindest eine Eigenschaft des ersten Magnetfeldsensors und/oder des zweiten Magnetfeldsensors zu ermitteln. Insbesondere ist die Magnetfeldsensor-Diagnoseeinheit dazu eingerichtet, das erfindungsgemäße Verfahren durchzuführen.

Die erfindungsgemäße Magnetfeldsensor-Diagnoseeinheit ist dafür derart eingerichtet, dass alle Magnetfeldsensoren des differentiellen Magnetfeldmesssystems mit mindestens zwei Magnetfeldsensoren zur Funktionsdiagnose mit einem gleichgerichteten Diagnosemagnetfeld gleicher Höhe beaufschlagt werden. Dabei wird dieses Diagnosemagnetfeld durch einen elektrischen Strom erzeugt, der in einen bezüglich den Magnetfeldsensoren entsprechend eingerichteten Signalleiter eingeprägt wird. Das Diagnosemagnetfeld wird unabhängig von seiner Stärke in dem differentiellen Messmagnetfeldsignal eliminiert, sofern keine Fehlfunktion eines Magnetfeldsensors vorliegt. Die Eliminierung erfolgt mittels Differenzbildung zwischen den Messsignalen der Magnetfeldsensoren jeweils aus der Überlagerung von Diagnosemagnetfeld und Messmagnetfeld. In den gemessenen Messsignalen der einzelnen Magnetfeldsensoren hingegen bleibt es enthalten. Durch die Eliminierung bleibt der Messbetrieb mit dem differentiellen Messmagnetfeldsignal von der Diagnose unbeeinflusst, auch bei driftendem Diagnosestrom und unabhängig von Amplitude, Frequenz und Toleranzen des Diagnosestromsignals.

Ein Vorteil dieser Ausführungsform ist, dass mithilfe der gleichen Messachsen der Magnetfeldsensoren mittels eines einzelnen Signalleiters, welcher an einem einzelnen Signalgeber angeschlossen sein kann, die Funktionsweise aller Magnetfeldsensoren überprüft werden können. Ferner kann dabei die Magnetfeldsensor-Diagnoseeinheit einen Signalleiter aufweisen, welcher an einer Vielzahl von Magnetfeldsensoren angeordnet ist, wobei jeweils alle der Vielzahlen von Magnetfeldsensoren eine gleiche Messachse aufweisen. Dabei können die Messachsen der Magnetfeldsensoren insbesondere die erste Messachse des ersten Magnetfeldsensors und die zweite Messachse des zweiten Magnetfeldsensors eine im Wesentlichen gleiche Ausrichtung bzw. Orientierung aufweisen. Im Wesentlichen gleich bedeutet in diesem Zusammenhang insbesondere einen fertigungsbedingten Versatz zueinander insbesondere eine Abweichung von ± 0° bis 5°. Darüber hinaus sind bevorzugt die erste Orientierung und die zweite Orientierung im Wesentlichen gleich. Im Wesentlichen gleich kann in diesem Zusammenhang insbesondere bedeuten, dass die erste Orientierung zur zweiten Orientierung in einer dreidimensionalen Ausrichtung maximal eine Abweichung von ± 5° aufweist, insbesondere lediglich eine fertigungstechnisch bedingte Toleranz aufweist. Darüber hinaus ist die Logikeinheit dazu eingerichtet, insbesondere das Verfahren wie voranstehend und nachfolgend beschrieben auszuführen bzw. durchzuführen, um eine Eigenschaft des zumindest einen Magnetfeldsensors zu bestimmen, welche beispielsweise ein Ausfall des Magnetfeldsensors oder eine Ungenauigkeit des Magnetfeldsensors sein kann. Bevorzugt kann der Signalleiter, insbesondere ein Stromleiter oder ähnliches sein. Ferner kann das Signal bspw. durch einen Strom und/oder Stromimpuls gebildet werden. Dabei kann die Magnetfeldsensor-Diagnoseeinheit insbesondere zum messbetriebsunterbrechungsfreien und diagnosestromdrifttoleranten Diagnose von Magnetfeldsensoren in Differential-Mode-Auswertung verwendet werden. Weiter bevorzugt kann die Magnetfeldsensor-Diagnoseeinheit als messbetriebsunterbrechungsfreier und diagnosestromdrifttolerant diagnostizierbare Differential-Mode-Magnetfeldsensor ausgebildet sein.

Weiter bevorzugt weist der Signalleiter eine dritte Orientierung und eine dritte Distanz zu einem dritten Magnetfeldsensor mit einer dritten Messachse auf, wobei die erste Messachse, die zweite Messachse und die dritte Messachse die im Wesentlichen gleiche relative Lage aufweisen, und wobei die erste Orientierung und die erste Distanz, die zweite Orientierung und die zweite Distanz und die dritte Orientierung und die dritte Distanz im Wesentlichen gleich sind. Dabei ist die Logikeinheit dazu eingerichtet, die Signalfolge mittels des ersten Magnetfeldsensors, des zweiten Magnetfeldsensors und des dritten Magnetfeldsensors zu erfassen, um zumindest eine Eigenschaft des ersten Magnetfeldsensors, des zweiten Magnetfeldsensors und/oder des dritten Magnetfeldsensors zu ermitteln.

Ein Vorteil dieser Ausführungsform kann sein, dass die Verwendung von drei oder mehr Magnetfeldsensoren auf einer Achse insbesondere einer Messachse die Kompensation linearer Störfeldanteile bei der Überwachung von Magnetfeldern ermöglicht. Dabei weisen der erste Magnetfeldsensor, der zweite Magnetfeldsensor und/oder der dritte Magnetfeldsensor eine im Wesentlichen gleiche Messachse auf, wobei im "Wesentlichen gleich" in diesem Zusammenhang insbesondere eine Abweichung von ± < 5° bedeutet, insbesondere eine fertigungsbedingte Toleranz. Zudem sind die erste Orientierung, die zweite Orientierung und die dritte Orientierung im Wesentlichen gleich, wobei im Wesentlichen gleich in diesem Zusammenhang eine Abweichung von ± < 5° umfasst, insbesondere in alle drei Achsen, wobei im Wesentlichen insbesondere eine fertigungsbedingte Toleranz bedeutet.

Weiter bevorzugt sind die erste Orientierung, die zweite Orientierung und/oder die dritte Orientierung in einem vorbestimmten Winkel zur ersten Messachse, zur zweiten Messachse und/oder zu dritten Messachse angeordnet.

Ein Vorteil dieser Ausführungsform ist, dass die mittels des vorbestimmten Winkels eine Erfassungsrichtung des Signals mittels der Magnetfeldsensoren gezielt eingestellt werden kann. Bevorzugterweise weisen die erste Orientierung, die zweite Orientierung und die dritte Orientierung einen Winkel von ungefähr 90° zur ersten Messachse, zur zweiten Messachse und zur dritten Messachse auf. Dabei kann ungefähr 90° eine Abweichung von ± < 5° umfassen.

Bevorzugt weist die Logikeinheit zumindest ein Speicherelement auf, wobei das Speicherelement dazu eingerichtet ist, zumindest eine Kalibrierung zumindest eines Diagnosemagnetfelds zumindest des ersten Magnetfeldsensors, des zweiten Magnetfeldsensors und/oder des dritten Magnetfeldsensors zu speichern, wobei die Logikeinheit (16) dazu eingerichtet ist, mittels der zumindest einen Kalibrierung die Bestimmung der zumindest einen Eigenschaft des zumindest einen Magnetfeldsensors anzupassen.

Ein Vorteil dieser Ausführungsform kann sein, dass für jeden Magnetfeldsensor beispielsweise in der Fertigung des Magnetfeldsensors eine Kalibrierung erstellt werden kann, um somit eventuelle Offsets oder ähnliches ausgleichen zu können.

Weiter bevorzugt umfasst die erste Orientierung einen ersten Teilabschnitt des Signalleiters und die zweite Orientierung einen zweiten Teilabschnitt des Signalleiters, wobei der Signalleiter ferner einen fünften Teilabschnitt umfasst, welcher eine fünfte Orientierung aufweist. Dabei ist die fünfte Orientierung im Wesentlichen entgegengesetzt zu der ersten Orientierung und der zweiten Orientierung ausgerichtet. Außerdem ist der fünfte Teilabschnitt des Signalleiters zwischen dem ersten Teilabschnitt des Signalleiters und dem zweiten Teilabschnitt des Signalleiters angeordnet, wobei der erste Teilabschnitt des Signalleiters, der zweite Teilabschnitt des Signalleiters und der fünfte Teilabschnitt des Signalleiters im Wesentlichen äquidistant zueinander angeordnet sind. Der besseren Verständlichkeit halber ist hier jeweils ein x-ter Teilabschnitt einer x-ten Orientierung zugeordnet.

Ein Vorteil dieser Ausführungsform ist, dass mittels äquidistanten bzw. gleichbleibendem und mittigen Anordnung des beschriebenen fünften Teilabschnitts, der einen Rückleitungsteilabschnitt darstellen kann, durch ihn erzeugte Magnetfeldsignale im ersten Magnetfeldsensor und zweiten Magnetfeldsensor gleichgerichtet und in gleicher Höhe gemessen werden können, sodass die aus den Teilabschnitten ursprünglichen und in den Magnetfeldsensoren sich überlagernden resultierenden Magnetfelder in beiden Magnetfeldsensoren weiterhin gleichgerichtet sind und die gleiche Höhe aufweisen, wodurch das Magnetfeldsignal, das für die Diagnose erzeugt wird, in dem differentiellen Messmagnetfeldsignal des differentiellen Magnetfeldmesssystems bevorzugt eliminiert bleibt und damit der Messbetrieb während der Diagnose auch mit Rückleitungsteilabschnitt erfolgen kann und die Unabhängigkeit von Drifts im Diagnosestrom gegeben sein kann.

Bevorzugt ist der Signalleiter anhand eines vorbestimmten Musters zum ersten Magnetfeldsensor und zum zweiten Magnetfeldsensor angeordnet. Weiterhin bevorzugt ist der Signalleiter anhand des vorbestimmten Musters zum ersten Magnetfeldsensor, zum zweiten Magnetfeldsensor und zum dritten Magnetfeldsensor angeordnet.

Ein Vorteil dieser Ausführungsform ist, dass abhängig vom Einsatzszenario bzw. vom vorhandenen Bauraum das Muster angepasst werden kann, um somit die Diagnoseeinheit besonders flexibel einsetzbar und kostengünstig zu gestalten.

Weiter bevorzugt handelt es sich bei dem ersten Magnetfeldsensor, dem zweiten Magnetfeldsensor und/oder dem dritten Magnetfeldsensor um einen multidifferentiell zu betreibenden bzw. auszuwertenden Magnetfeldsensor.

Weiter bevorzugt weist das erste Signal und das zweite Signal eine im Wesentlichen gleiche magnetische Feldstärke auf. Im Wesentlichen gleich kann in diesem Zusammenhang eine Abweichung von bis +/-25% zwischen dem ersten Signal und dem zweiten Signal bedeuten.

Ein weiterer Aspekt der Erfindung betrifft eine Antriebseinheit für ein Fahrzeug, insbesondere ein elektrisch angetriebenes Fahrrad, mit einer Magnetfeldsensor-Diagnoseeinheit, wie voranstehend und nachfolgend beschrieben, und/oder einer Steuereinheit, welche dazu eingerichtet ist, das Verfahren wie voranstehend und nachfolgend beschrieben auszuführen.

Ein weiterer Aspekt der Erfindung betrifft die Verwendung einer Magnetfeldsensor-Diagnoseeinheit, wie voranstehend und nachfolgend beschrieben, zur, insbesondere messbetriebsunterbrechungsfreien und diagnosestromdrifttoleranten Funktionsdiagnose von Magnetfeldsensoren in einem differentiellen Magnetfeldmesssystem.

### Zeichnungen

Nachfolgend werden Ausführungsbeispiele der Erfindung unter Bezugnahme auf die begleitende Zeichnung im Detail beschrieben. In der Zeichnung ist:
Figur 1 bis 9 eine Magnetfeldsensor-Diagnoseeinheit gemäß einer Ausführungsform,
Figur 10 ein Flussdiagramm zur Illustration von Schritten des Verfahrens gemäß einer Ausführungsform,
Figur 11 ein Flussdiagramm zur Illustration von Schritten gemäß einer Ausführungsform,
Figur 12 ein Fahrzeug gemäß einer Ausführungsform.

### Ausführungsformen der Erfindung

Bevorzugt sind alle gleichen Elemente, Bauteil und/oder Einheiten in allen Figuren mit den gleichen Bezugszeichen versehen.

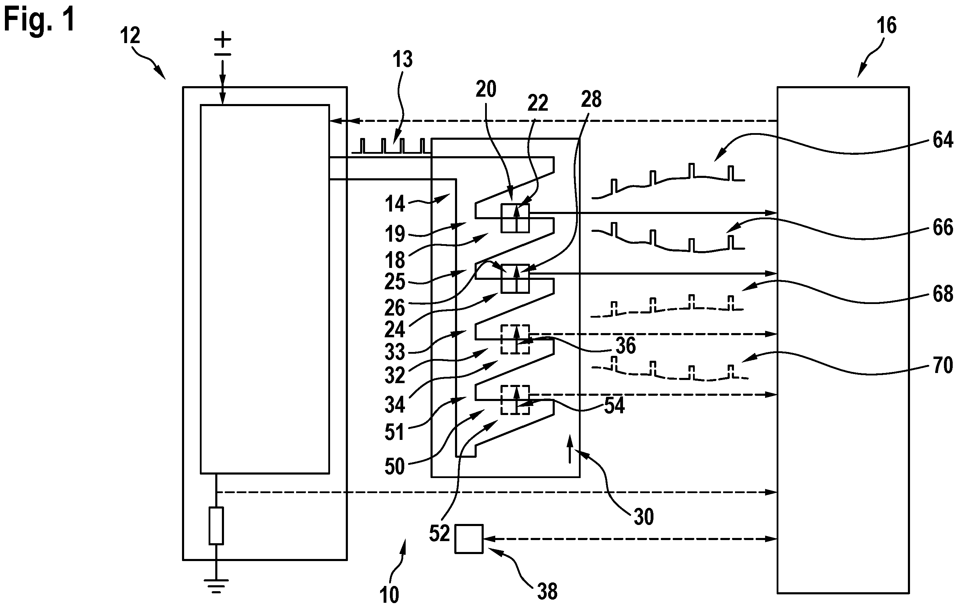

Figur 1 zeigt eine Magnetfeldsensor-Diagnoseeinheit zur messbetriebsunterbrechungsfreien und diagnosestromdrifttoleranten Funktionsdiagnose von Magnetfeldsensoren in differentiellen Magnetfeldmesssystemen 10 gemäß einer Ausführungsform vorzugsweise mit zumindest zwei Magnetfeldsensoren 20 und 26 sowie bevorzugt einem weiteren Magnetfeldsensor 34 oder weiteren Magnetfeldsensoren 34 und 52 und umfasst einen Diagnosestromsignaltreiber 12 bzw. einen Signaltreiber 12, welcher signalleitend mit einem Signalleiter 14 verbunden ist, und eine Logikeinheit 16, welche dazu eingerichtet ist, eine Diagnosestromsignalfolge bzw. eine Signalfolge mit zumindest zwei unterschiedlichen Stromwerten, bzw. Werten mittels des Diagnosestromsignaltreibers 12 zu erzeugen. Die Signalfolge kann dabei vorzugsweise ein pulsförmiges Diagnosestromsignal 13 sein. Der Diagnosestromsignaltreiber 12 bzw. der Signaltreiber 12 kann dabei die Signalfolge bzw. das Diagnosestromsignal 13 in den Signalleiter 14 leiten. Der Signalleiter 14 ist dabei so angeordnet, dass der Signalleiter 14 eine erste Orientierung 18 und Distanz 19 zum ersten Magnetfeldsensor 20 aufweist. Der erste Magnetfeldsensor 20 weist eine erste Messachse 22 auf. Des Weiteren ist der Signalleiter 14 derart angeordnet, dass dieser eine zweite Orientierung 24 und Distanz 25 zum zweiten Magnetfeldsensor 26 aufweist. Der zweite Magnetfeldsensor 26 weist eine zweite Messachse 28 auf. Die erste Messachse 22 und die zweite Messachse 28 sind dabei im Wesentlichen gleich ausgerichtet bzw. weisen im Wesentlichen dieselbe relative Lage 30 auf, wobei in Figur 1 die relative Lage 30 beispielhaft mit einer bevorzugten Orientierung dargestellt ist und die relative Lage 30 alternativ mit einer anderen Orientierung ausgestaltet sein kann. Ferner sind die Orientierungen 18 und 24 sowie die Distanzen 19 und 25 des Signalleiters 14 zu den Magnetfeldsensoren 20 und 26 dabei im Wesentlichen gleich. Weiter bevorzugt ist der Signalleiter 14 in einer dritten Orientierung 32 und Distanz 33 zu einem dritten Magnetfeldsensor 34 angeordnet, welcher eine dritte Messachse 36 aufweist. Die dritte Messachse 36 weist dabei im Wesentlichen eine gleiche Ausrichtung bzw. die gleiche relative Lage 30 auf wie die erste Messachse 22 und die zweite Messachse 28. Ferner sind die Orientierungen 18, 24 und 32 sowie die Distanzen 19, 25 und 33 des Signalleiters 14 zu den Magnetfeldsensoren 20, 26 und 34 dabei im Wesentlichen gleich. Ferner bevorzugt ist der Signalleiter 14 in einer vierten Orientierung 50 und Distanz 51 zu einem vierten Magnetfeldsensor 52 angeordnet. Der vierte Magnetfeldsensor 52 weist dabei eine vierte Messachse 54 auf, welche im Wesentlichen die gleiche Orientierung wie die vorbestimmte relative Lage 30 aufweist bzw. welche im Wesentlichen die gleiche Ausrichtung aufweist, wie die erste Messachse 22, die zweite Messachse 28 und die dritte Messachse 36. Ferner sind die Orientierungen 18, 24, 32, 50 sowie die Distanzen 19, 25, 33, 51 des Signalleiters 14 zu den Magnetfeldsensoren 20, 26, 34, 52 dabei im Wesentlichen gleich.

Weiter bevorzugt sind die Magnetfeldsensoren 20, 26, bzw. 20, 26, 34, bzw. 20, 26, 34, 52 des differentiellen Magnetfeldmesssystems auf einem PCB bestückt, in welchem weiter bevorzugt der Signalleiter 14 geführt wird.

Ferner bevorzugt weist die Magnetfeldsensor-Diagnoseeinheit 10 zur messbetriebsunterbrechungsfreien und diagnosestromdrifttoleranten Funktionsdiagnose von Magnetfeldsensoren in differentiellen Magnetfeldmesssystemen ein Speicherelement 38 auf, welches zumindest eine Kalibrierung eines Diagnosemagnetfelds des ersten Magnetfeldsensors 20, des zweiten Magnetfeldsensors 26, des dritten Magnetfeldsensors 34 und/oder des vierten Magnetfeldsensors 52 aufweist. Ferner zeigt die Figur 1 schematisch ein erstes, vom ersten Magnetfeldsensor 20 erfasstes, Messsignal 64, umfassend eine Überlagerung von einem Messmagnetfeldsignal und einem durch das Diagnosestromsignal 13 erzeugte Diagnosemagnetfeldsignal. Ebenso zeigt die Figur 1 ein zweites, vom zweiten Magnetfeldsensor 26 erfasstes, Messsignal 66, umfassend eine Überlagerung von einem weiteren Messmagnetfeldsignal und einem durch das Diagnosestromsignal 13 erzeugte Diagnosemagnetfeldsignal. Ferner wird in der Figur 1 ein drittes, vom dritten Magnetfeldsensor 34 erfasstes, Messsignal 68 dargestellt, umfassend eine Überlagerung von einem weiteren Messmagnetfeldsignal und einem durch das Diagnosestromsignal 13 erzeugte Diagnosemagnetfeldsignal. Des Weiteren wird ein viertes, vom vierten Magnetfeldsensor 52 erfasstes, Messsignal 70 dargestellt, umfassend eine Überlagerung von einem weiteren Messmagnetfeldsignal und einem durch das Diagnosestromsignal 13 erzeugte Diagnosemagnetfeldsignal. Durch die voranstehend beschriebenen Anordnungen innerhalb der Magnetfeldsensor-Diagnoseeinheit 10 ergibt sich in den Messachsen der Magnetfeldsensoren ein jeweils gleichgerichtetes Diagnosemagnetfeld gleicher Stärke, hervorgerufen durch ein Signal bzw. das Diagnosestromsignal 13 im Signalleiter 14, wobei sich das Diagnosemagnetfeld durch Differenzbildung zwischen den Messsignalen der Magnetfeldsensoren in dem differentiellen Messmagnetfeldsignal der Messgröße des differentiellen Magnetfeldmesssystems eliminieren lässt für einen unterbrechungsfreien Messbetrieb. Dies lässt sich mittels der Anordnung unabhängig von der Höhe des Diagnosestroms erreichen, sodass sich ebenso eine Toleranz, Robustheit bzw. Unabhängigkeit gegenüber Diagnosestromdrifts, beispielsweise über Temperatur, ergibt. Ferner lässt sich jeder Magnetfeldsensor separat diagnostizieren oder bevorzugt lassen sich jeweils zwei Magnetfeldsensoren differentiell diagnostizieren oder weiter bevorzugt lassen sich jeweils zwei Magnetfeldsensoren in hybrider Weise differentiell und einzeln zugleich diagnostizieren wodurch sich die Toleranz, Robustheit bzw. Unabhängigkeit gegenüber Diagnosestromdrifts auch für die Funktionsdiagnose ergibt, welche sich messbetriebsunterbrechungsfrei ausführen lässt. Bevorzugt umfasst die Magnetfeldsensor-Diagnoseeinheit 10 zur messbetriebsunterbrechungsfreien und diagnosestromdrifttoleranten Funktionsdiagnose von Magnetfeldsensoren in differentiellen Magnetfeldmesssystemen die Logikeinheit 16, welche vorzugsweise dazu eingerichtet ist, das Verfahren 100, wie voranstehend und nachfolgend beschrieben auszuführen.

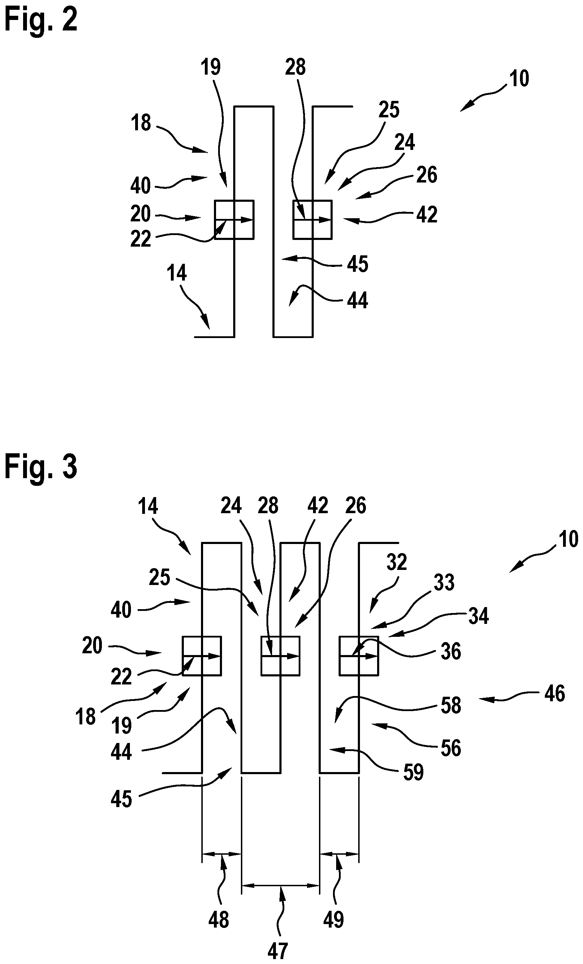

Figur 2 zeigt eine Magnetfeldsensor-Diagnoseeinheit 10 zur messbetriebsunterbrechungsfreien und diagnosestromdrifttoleranten Funktionsdiagnose von Magnetfeldsensoren in differentiellen Magnetfeldmesssystemen, welche einen Signalleiter 14 aufweist, der von einem Diagnosestromsignaltreiber 12 bzw. Signaltreiber 12 (in Figur 2 nicht dargestellt, vgl. Figur 1) gespeist werden kann. Der Signalleiter 14 ist dabei in einer ersten Orientierung 18 und Distanz 19 zum ersten Magnetfeldsensor 20 mit erster Messachse 22 angeordnet. Die erste Orientierung 18 weist bevorzugt einen ersten Teilabschnitt 40 auf. Ferner ist der Signalleiter 14 in einer zweiten Orientierung 24 und Distanz 25 zum zweiten Magnetfeldsensor 26 mit zweiter Messachse 28 angeordnet. Die zweite Orientierung 24 umfasst vorzugsweise einen zweiten Teilabschnitt 42. Die erste Messachse 22 und die zweite Messachse 28 weisen dabei im Wesentlichen eine gleiche Ausrichtung bzw. relative Lage auf. Ferner sind vorzugsweise die Orientierungen 18 und 24 sowie Distanzen 19 und 25 des Signalleiters 14 zu den Magnetfeldsensoren 20 und 26 im Wesentlichen gleich. Ferner ist bevorzugt der Signalleiter 14 in einer fünften Orientierung 44 zu der ersten Messachse 22 und der zweiten Messachse 28 angeordnet. Die fünfte Orientierung 44 ist bevorzugt im Wesentlichen entgegengesetzt zu der ersten Orientierung 18 und der zweiten Orientierung 24 und umfasst vorzugsweise einen fünften Teilabschnitt 45. Der fünfte Teilabschnitt 45 ist vorzugsweise zwischen dem ersten Teilabschnitt 40 und dem zweiten Teilabschnitt 42 angeordnet. Der erste Teilabschnitt 40, der zweite Teilabschnitt 42 und der fünfte Teilabschnitt 45 sind dabei vorzugsweise im Wesentlichen äquidistant zueinander angeordnet. Weiter bevorzugt sind die Magnetfeldsensoren 20 und 26 des differentiellen Magnetfeldmesssystems auf einem PCB bestückt, in welchem weiter bevorzugt der Signalleiter 14 geführt wird.

Figur 3 zeigt eine Magnetfeldsensor-Diagnoseeinheit 10 zur messbetriebsunterbrechungsfreien und diagnosestromdrifttoleranten Funktionsdiagnose von Magnetfeldsensoren in differentiellen Magnetfeldmesssystemen mit einem Signalleiter 14, der von einem Diagnosestromsignaltreiber 12 bzw. Signaltreiber 12 (in Figur 3 nicht dargestellt, vgl. Figur 1) gespeist werden kann. Der Signalleiter 14 ist in einer ersten Orientierung 18 und Distanz 19 zum ersten Magnetfeldsensor 20 mit erster Messachse 22 angeordnet. Ferner ist der Signalleiter 14 in einer zweiten Orientierung 24 und Distanz 25 zum zweiten Magnetfeldsensor 26 mit zweiter Messachse 28 angeordnet. Darüber hinaus ist der Signalleiter 14 in einer dritten Orientierung 32 und Distanz 33 zum dritten Magnetfeldsensor 34 mit dritter Messachse 36 angeordnet. Vorzugsweise weist die erste Orientierung 18 einen ersten Teilabschnitt 40 auf, die zweite Orientierung 24 einen zweiten Teilabschnitt 42 und die dritte Orientierung 32 einen dritten Teilabschnitt 56 auf. Die erste Messachse 22, die zweite Messachse 28 und die dritte Messachse 36 weisen im Wesentlichen eine gleiche Ausrichtung bzw. relative Lage auf. Ferner sind die Orientierungen 18, 24, 32 sowie die Distanzen 19, 25, 33 des Signalleiters 14 zu den Magnetfeldsensoren 20, 26, 34 im Wesentlichen gleich. Vorzugsweise ist der Signalleiter 14 in einer fünften Orientierung 44 und sechsten Orientierung 58 zu der ersten Messachse 22, der zweiten Messachse 28 und der dritten Messachse 36 angeordnet. Die fünfte Orientierung 44 und die sechste Orientierung 58 sind bevorzugt beide im Wesentlichen entgegengesetzt zu der ersten Orientierung 18, der zweiten Orientierung 24 und der dritten Orientierung 32. Weiter bevorzugt weist die fünfte Orientierung 44 einen fünften Teilabschnitt 45 auf und die sechste Orientierung 58 einen sechsten Teilabschnitt 59 auf. Der fünfte Teilabschnitt 45 ist vorzugsweise zwischen dem ersten Teilabschnitt 40 und dem zweiten Teilabschnitt 42 angeordnet. Der sechste Teilabschnitt 59 ist bevorzugt zwischen dem zweiten Teilabschnitt 42 und dem dritten Teilabschnitt 56 angeordnet. Dabei kann der vorbestimmte Abstand 47 zwischen dem fünften Teilabschnitt 45 und dem sechsten Teilabschnitt 59 gleich oder bevorzugt größer sein als das Zweifache des Abstands 48 zwischen dem ersten Teilabschnitt 40 und dem fünften Teilabschnitt 45 und/oder des Abstands 49 zwischen dem sechsten Teilabschnitt 59 und dem dritten Teilabschnitt 56. Dabei sind bevorzugt die Abstände 48, 49 im Wesentlichen gleich. Dabei kann der Signalleiter 14 in einem vorbestimmten Muster 46 nach der vorangegangenen Beschreibung angeordnet sein und/oder wie in Figur 3 bspw. dargestellt ist. Weiter bevorzugt sind die Magnetfeldsensoren 20, 26, 34 des differentiellen Magnetfeldmesssystems auf einem PCB bestückt, in welchem weiter bevorzugt der Signalleiter 14 geführt wird.

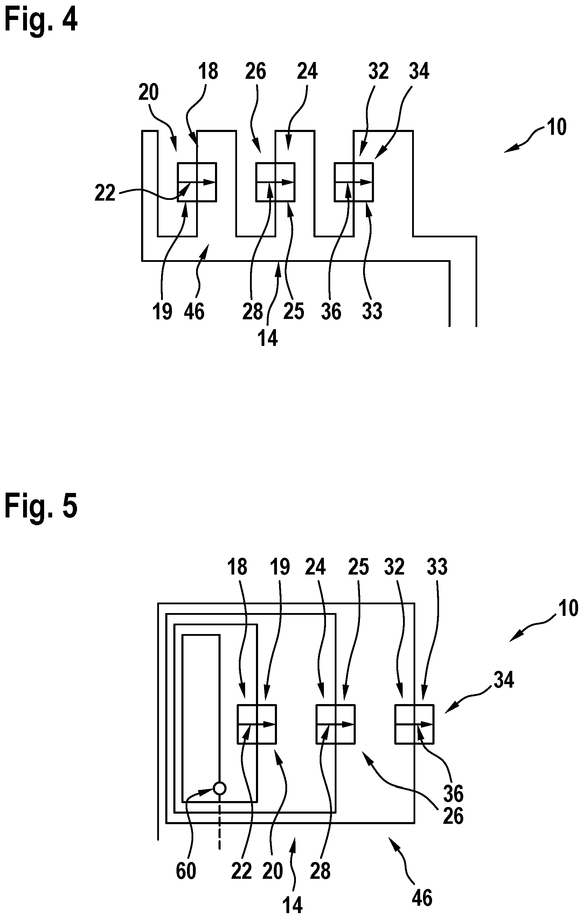

Figur 4 zeigt eine Magnetfeldsensor-Diagnoseeinheit 10 zur messbetriebsunterbrechungsfreien und diagnosestromdrifttoleranten Funktionsdiagnose von Magnetfeldsensoren in differentiellen Magnetfeldmesssystemen mit einem Signalleiter 14, der in einem vorbestimmten Muster 46 angeordnet ist und der von einem Diagnosestromsignaltreiber 12 bzw. Signaltreiber 12 (in Figur 4 nicht dargestellt, vgl. Figur 1) gespeist werden kann. Wie in Figur 4 gezeigt ist, ist bevorzugt das vorbestimmte Muster 46 insbesondere in einer Art Schlangenform angeordnet. Der Signalleiter 14 ist in einer ersten Orientierung 18 und Distanz 19 zum ersten Magnetfeldsensor 20 angeordnet sowie in einer zweiten Orientierung 24 und Distanz 25 zum zweiten Magnetfeldsensor 26. Darüber hinaus ist der Signalleiter 14 in der dritten Orientierung 32 und Distanz 33 zum dritten Magnetfeldsensor 34 angeordnet. Dabei sind die Orientierungen 18, 24, 32, sowie die Distanzen 19, 25, 33 im Wesentlichen gleich. Ferner weist der erste Magnetfeldsensor 20 eine erste Messachse 22, der zweite Magnetfeldsensor 26 eine zweite Messachse 28 und der dritte Magnetfeldsensor 34 eine dritte Messachse 36 auf. Die Messachsen 22, 28, 36 der Magnetfeldsensoren 20, 26, 34 sind im Wesentlichen gleich ausgerichtet bzw. weisen im Wesentlichen die gleiche relative Lage auf. Weiter bevorzugt sind die Magnetfeldsensoren 20, 26, 34 des differentiellen Magnetfeldmesssystems auf einem PCB bestückt, in welchem weiter bevorzugt der Signalleiter 14 geführt wird.

Figur 5 zeigt eine Magnetfeldsensor-Diagnoseeinheit 10 zur messbetriebsunterbrechungsfreien und diagnosestromdrifttoleranten Funktionsdiagnose von Magnetfeldsensoren in differentiellen Magnetfeldmesssystemen mit einem Signalleiter 14, der in einem vorbestimmten Muster 46 angeordnet ist und der von einem Diagnosestromsignaltreiber 12 bzw. Signaltreiber 12 (in Figur 5 nicht dargestellt, vgl. Figur 1) gespeist werden kann. Wie in der Figur 5 gezeigt ist, ist bevorzugt das vorbestimmte Muster 46 insbesondere in einer Art Schneckenform angeordnet. Dabei sind die erste Orientierung 18 und Distanz 19 des Signalleiters 14 zum ersten Magnetfeldsensor 20, die zweite Orientierung 24 und Distanz 25 des Signalleiters 14 zum zweiten Magnetfeldsensor 26 und die dritte Orientierung 32 und Distanz 33 des Signalleiters 14 zum dritten Magnetfeldsensor 34 im Wesentlichen gleich. Ferner weist der erste Magnetfeldsensor 20 eine erste Messachse 22, der zweite Magnetfeldsensor 26 eine zweite Messachse 28 und der dritte Magnetfeldsensor 34 eine dritte Messachse 36 auf. Die Messachsen 22, 28, 36 der Magnetfeldsensoren 20, 26, 34 sind dabei im Wesentlichen gleich ausgerichtet bzw. weisen im Wesentlichen die gleiche relative Lage auf. Bevorzugt weist der Signalleiter 14 eine Übergangsstelle 60 in eine weitere räumliche Ebene auf. Die Übergangsstelle 60 kann dabei den Signalleiter 14 beispielsweise von einer ersten Lage eines PCBs auf eine zweite Lage des PCBs führen. Weiter bevorzugt sind die Magnetfeldsensoren 20, 26, 34 des differentiellen Magnetfeldmesssystems auf dem PCB bestückt, in welchem weiter bevorzugt der Signalleiter 14 geführt wird.

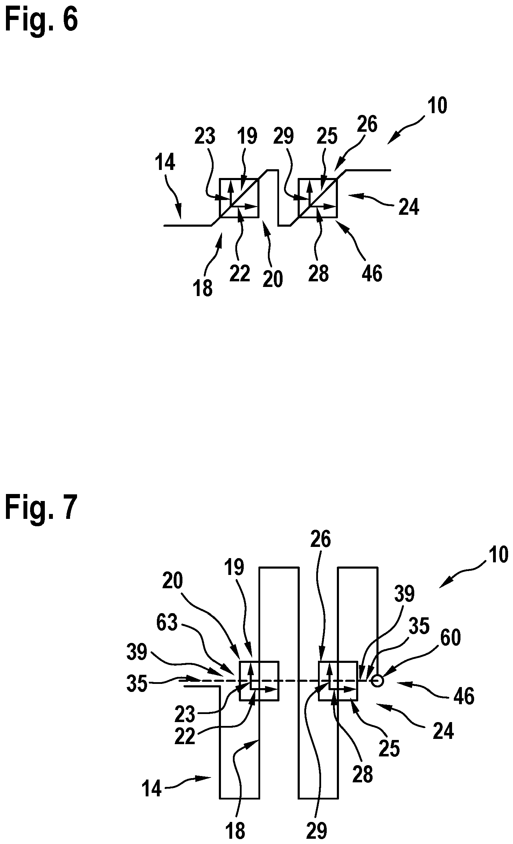

Figur 6 zeigt eine Magnetfeldsensor-Diagnoseeinheit 10 zur messbetriebsunterbrechungsfreien und diagnosestromdrifttoleranten Funktionsdiagnose von Magnetfeldsensoren in differentiellen Magnetfeldmesssystemen mit einem Signalleiter 14, der von einem Diagnosestromsignaltreiber 12 bzw. Signaltreiber 12 (in Figur 6 nicht dargestellt, vgl. Figur 1) gespeist werden kann. Der Signalleiter 14 ist bevorzugt, wie in Figur 6 dargestellt, in einem vorbestimmten Muster 46 bspw. einer Art Z-Form angeordnet. Wie in Figur 6 dargestellt, sind die erste Orientierung 18 und Distanz 19 des Signalleiters 14 zum ersten Magnetfeldsensor 20 und die zweite Orientierung 24 und Distanz 25 des Signalleiters 14 zum zweiten Magnetfeldsensor 26 dabei im Wesentlichen gleich. Bevorzugt weist der erste Magnetfeldsensor 20 eine weitere Messachse 23 auf, wobei die weitere Messachse 23 des ersten Magnetfeldsensors 20 zur ersten Messachse 22 des ersten Magnetfeldsensors 20 im Wesentlichen orthogonal ausgerichtet ist. Vorzugsweise weist der zweite Magnetfeldsensor 26 eine weitere Messachse 29 auf, wobei die weitere Messachse 29 des zweiten Magnetfeldsensors 26 zur zweiten Messachse 28 des zweiten Magnetfeldsensors 26 im Wesentlichen orthogonal ausgerichtet ist. Die weiteren Messachsen 23, 29 der Magnetfeldsensoren 20, 26 sind dabei im Wesentlichen gleich ausgerichtet, bzw. weisen im Wesentlichen die gleiche relative Lage auf. Weiter bevorzugt sind die Magnetfeldsensoren 20, 26 des differentiellen Magnetfeldmesssystems auf einem PCB bestückt, in welchem weiter bevorzugt der Signalleiter 14 geführt wird.

Figur 7 zeigt eine Magnetfeldsensor-Diagnoseeinheit 10 zur messbetriebsunterbrechungsfreien und diagnosestromdrifttoleranten Funktionsdiagnose von Magnetfeldsensoren in differentiellen Magnetfeldmesssystemen mit einem Signalleiter 14, der von einem Diagnosestromsignaltreiber 12 bzw. Signaltreiber 12 (in Figur 7 nicht dargestellt, vgl. Figur 1) gespeist werden kann. Wie in Figur 7 dargestellt, sind die erste Orientierung 18 und Distanz 19 des Signalleiters 14 zum ersten Magnetfeldsensor 20 und die zweite Orientierung 24 und Distanz 25 des Signalleiters 14 zum zweiten Magnetfeldsensor 26 im Wesentlichen gleich. Bevorzugt weist der erste Magnetfeldsensor 20 eine weitere Messachse 23 auf, wobei die weitere Messachse 23 des ersten Magnetfeldsensors 20 zur ersten Messachse 22 des ersten Magnetfeldsensors 20 im Wesentlichen orthogonal ausgerichtet ist. Vorzugsweise weist der zweite Magnetfeldsensor 26 eine weitere Messachse 29 auf, wobei die weitere Messachse 29 des zweiten Magnetfeldsensors 26 zur zweiten Messachse 28 des zweiten Magnetfeldsensors 26 im Wesentlichen orthogonal ausgerichtet ist. Die weiteren Messachsen 23, 29 der Magnetfeldsensoren 20, 26 sind dabei im Wesentlichen gleich orientiert. Der Signalleiter 14 ist vorzugsweise zu dem ersten Magnetfeldsensor 20 und dem zweiten Magnetfeldsensor 26 jeweils in derselben weiteren siebten Orientierung 35 und Distanz 39 angeordnet, wobei die siebte Orientierung 35 im Wesentlichen orthogonal zu den Orientierungen 18 und 24 ist. Die siebte Orientierung 35 weist bevorzugt einen siebten Teilabschnitt 63 auf. Der siebte Teilabschnitt 63 liegt dabei in einer weiteren räumlichen Ebene. Weiter bevorzugt ist der Signalleiter 14 in einem vorbestimmten Muster 46, wie in Figur 7 dargestellt, angeordnet. Des Weiteren weist der Signalleiter 14 eine Übergangsstelle 60 in die weitere räumliche Ebene auf. Die Übergangsstelle 60 kann dabei den Signalleiter 14 beispielsweise von einer ersten Lage eines PCBs auf eine zweite Lage des PCBs führen. Weiter bevorzugt sind die Magnetfeldsensoren 20, 26 des differentiellen Magnetfeldmesssystems auf dem PCB bestückt, in welchem weiter bevorzugt der Signalleiter 14 geführt wird.

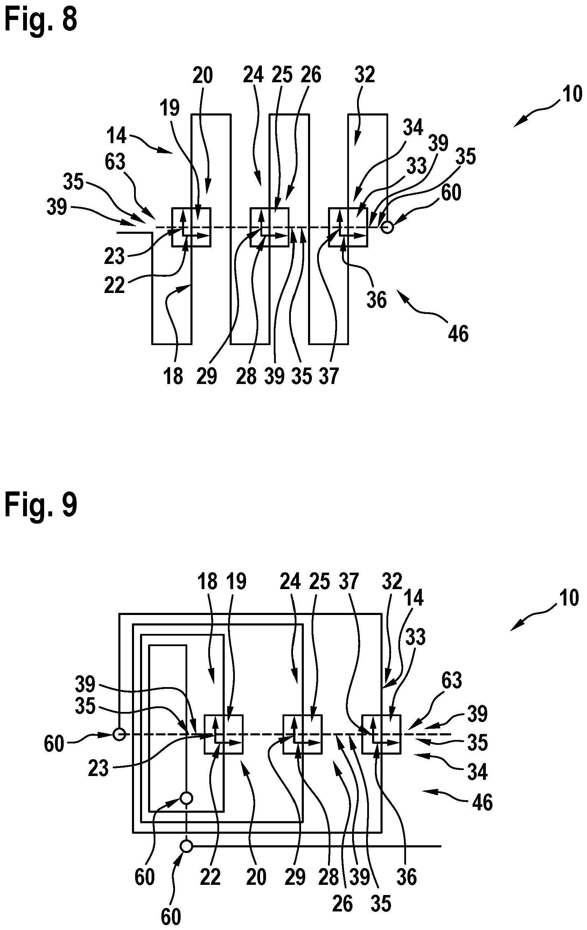

Figur 8 zeigt eine Magnetfeldsensor-Diagnoseeinheit 10 zur messbetriebsunterbrechungsfreien und diagnosestromdrifttoleranten Funktionsdiagnose von Magnetfeldsensoren in differentiellen Magnetfeldmesssystemen mit einem Signalleiter 14, der von einem Diagnosestromsignaltreiber 12 bzw. Signaltreiber 12 (in Figur 8 nicht dargestellt, vgl. Figur 1) gespeist werden kann. Wie in Figur 8 dargestellt, sind die erste Orientierung 18 und Distanz 19 des Signalleiters 14 zum ersten Magnetfeldsensor 20, die zweite Orientierung 24 und Distanz 25 des Signalleiters 14 zum zweiten Magnetfeldsensor 26 und die dritte Orientierung 32 und Distanz 33 des Signalleiters 14 zum dritten Magnetfeldsensor 34 im Wesentlichen gleich. Vorzugsweise weist der erste Magnetfeldsensor 20 eine weitere Messachse 23 auf, wobei die weitere Messachse 23 des ersten Magnetfeldsensors 20 zur ersten Messachse 22 des ersten Magnetfeldsensors 20 im Wesentlichen orthogonal ausgerichtet ist. Bevorzugt weist der zweite Magnetfeldsensor 26 eine weitere Messachse 29 auf, wobei die weitere Messachse 29 des zweiten Magnetfeldsensors 26 zur zweiten Messachse 28 des zweiten Magnetfeldsensors 26 im Wesentlichen orthogonal ausgerichtet ist. Weiter bevorzugt weist der dritte Magnetfeldsensor 34 eine weitere Messachse 37 auf, wobei die weitere Messachse 37 des dritten Magnetfeldsensors 34 zur dritten Messachse 36 des dritten Magnetfeldsensors 34 im Wesentlichen orthogonal ausgerichtet ist. Die weiteren Messachsen 23, 29, 37 der Magnetfeldsensoren 20, 26, 34 sind dabei im Wesentlichen gleich ausgerichtet bzw. weisen im Wesentlichen die gleiche relative Lage auf.

Der Signalleiter 14 ist bevorzugt zu dem ersten Magnetfeldsensor 20, zu dem zweiten Magnetfeldsensor 26 und zu dem dritten Magnetfeldsensor 34 jeweils in derselben weiteren siebten Orientierung 35 und Distanz 39 angeordnet, wobei die siebte Orientierung 35 im Wesentlichen orthogonal zu den Orientierungen 18, 24 und 32 ist. Die siebte Orientierung 35 weist bevorzugt einen siebten Teilabschnitt 63 auf. Der siebte Teilabschnitt 63 liegt dabei in einer weiteren räumlichen Ebene. Weiter bevorzugt ist der Signalleiter 14 in einem vorbestimmten Muster 46, wie in Figur 8 dargestellt, angeordnet. Des Weiteren weist der Signalleiter 14 eine Übergangsstelle 60 in die weitere räumliche Ebene auf. Die Übergangsstelle 60 kann dabei den Signalleiter 14 beispielsweise von einer ersten Lage eines PCBs auf eine zweite Lage des PCBs führen. Weiter bevorzugt sind die Magnetfeldsensoren 20, 26, 34 des differentiellen Magnetfeldmesssystems auf dem PCB bestückt, in welchem weiter bevorzugt der Signalleiter 14 geführt wird.

Figur 9 zeigt eine Magnetfeldsensor-Diagnoseeinheit 10 zur messbetriebsunterbrechungsfreien und diagnosestromdrifttoleranten Funktionsdiagnose von Magnetfeldsensoren in differentiellen Magnetfeldmesssystemen mit einem Signalleiter 14, welcher anhand eines vorbestimmten Musters 46 angeordnet ist und der von einem Diagnosestromsignaltreiber 12 bzw. Signaltreiber 12 (in Figur 9 nicht dargestellt, vgl. Figur 1) gespeist werden kann. Das vorbestimmte Muster 46 ist bevorzugt wie in Figur 9 dargestellt als eine Art Schneckenform ausgebildet. Dabei sind die erste Orientierung 18 und Distanz 19 des Signalleiters 14 zum ersten Magnetfeldsensor 20, die zweite Orientierung 24 und Distanz 25 des Signalleiters 14 zum zweiten Magnetfeldsensor 26 und die dritte Orientierung 32 und Distanz 33 des Signalleiters 14 zum dritten Magnetfeldsensor 34 im Wesentlichen gleich. Bevorzugt weist der erste Magnetfeldsensor 20 eine weitere Messachse 23 auf, wobei die weitere Messachse 23 des ersten Magnetfeldsensors 20 zur ersten Messachse 22 des ersten Magnetfeldsensors 20 im Wesentlichen orthogonal ausgerichtet ist. Vorzugsweise weist der zweite Magnetfeldsensor 26 eine weitere Messachse 29 auf, wobei die weitere Messachse 29 des zweiten Magnetfeldsensors 26 zur zweiten Messachse 28 des zweiten Magnetfeldsensors 26 im Wesentlichen orthogonal ausgerichtet ist. Bevorzugt weist der dritte Magnetfeldsensor 34 eine weitere Messachse 37 auf, wobei die weitere Messachse 37 des dritten Magnetfeldsensors 34 zur dritten Messachse 36 des dritten Magnetfeldsensors 34 im Wesentlichen orthogonal ausgerichtet ist. Die weiteren Messachsen 23, 29, 37 der Magnetfeldsensoren 20, 26, 34 sind dabei im Wesentlichen gleich ausgerichtet, bzw. weisen im Wesentlichen die gleiche relative Lage auf. Der Signalleiter 14 ist vorzugsweise zu dem ersten Magnetfeldsensor 20, zu dem zweiten Magnetfeldsensor 26 und zu dem dritten Magnetfeldsensor 34 jeweils in derselben weiteren siebten Orientierung 35 und Distanz 39 angeordnet, wobei die siebte Orientierung 35 im Wesentlichen orthogonal zu den Orientierungen 18, 24, 32 ist. Die siebte Orientierung 35 weist weiter bevorzugt einen siebten Teilabschnitt 63 auf. Der siebte Teilabschnitt 63 liegt dabei in einer weiteren räumlichen Ebene. Des Weiteren weist der Signalleiter 14 eine Übergangsstelle 60 in die weitere räumliche Ebene auf. Die Übergangsstelle 60 kann dabei den Signalleiter 14 dabei beispielsweise von einer ersten Lage eines PCBs auf eine zweite Lage des PCBs führen. Weiter bevorzugt sind die Magnetfeldsensoren 20, 26, 34 des differentiellen Magnetfeldmesssystems auf dem PCB bestückt, in welchem weiter bevorzugt der Signalleiter 14 geführt wird.

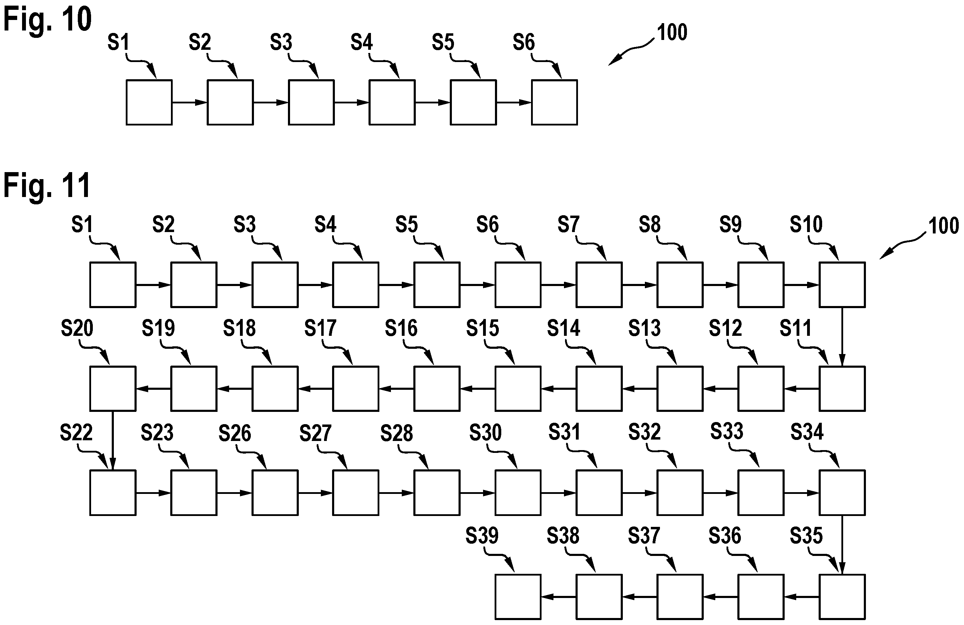

Figur 10 zeigt ein Flussdiagramm zur Illustration von Schritten gemäß des Verfahrens 100 zur messbetriebsunterbrechungsfreien und diagnosestromdrifttoleranten Funktionsdiagnose und/oder Fehlerdiagnose von Magnetfeldsensoren in differentiellen Magnetfeldmesssystemen mittels einer Magnetfeldsensor-Diagnoseeinheit 10, aufweisend die Schritte:
- Erzeugen S1 eines ersten Diagnosestroms bzw. ersten Signals mit einem ersten Wert in einen Signalleiter 14,
- Erfassen S2 jeweils eines ersten Messsignals umfassend eine Überlagerung von einem Messmagnetfeldsignal und einem durch das erste Signal erzeugte Diagnosemagnetfeldsignal mittels einer ersten Messung durch einen ersten Magnetfeldsensor 20 mit einer ersten Messachse 22 und durch einen zweiten Magnetfeldsensor 26 mit einer zweiten Messachse 28, wobei die erste Messachse 22 und die zweite Messachse 28 im Wesentlichen eine gleiche Ausrichtung bzw. eine im Wesentlichen gleiche relative Lage 30 aufweisen,
- Erzeugen S3 eines zweiten Diagnosestroms bzw. zweiten Signals mit einem zweiten Wert in den Signalleiter 14,
- Erfassen S4 jeweils eines zweiten Messsignals umfassend eine Überlagerung von einem Messmagnetfeldsignal und einem durch das zweite Signal erzeugte Diagnosemagnetfeldsignal mittels einer zweiten Messung durch den ersten Magnetfeldsensor 20 und durch den zweiten Magnetfeldsensor 26,
- Bilden S5 einer ersten Differenz zwischen dem zweiten Messsignal und dem ersten Messsignal des ersten Magnetfeldsensors 20 und Bilden S9 einer zweiten Differenz zwischen dem zweiten Messsignal und dem ersten Messsignal des zweiten Magnetfeldsensors 26,
- Ermitteln S6 der zumindest einen Eigenschaft des ersten Magnetfeldsensors 20 und/oder des zweiten Magnetfeldsensors 26 basierend auf der ersten Differenz und der zweiten Differenz.

Ferner kann insbesondere durch die Verwendung der Magnetfeldsensor-Diagnoseeinheit 10 und damit durch das fortlaufende Bilden eines vom Diagnosemagnetfeldsignal bereinigten differentiellen Messmagnetfeldsignals als Messgröße des differentiellen Magnetfeldmesssystems durch diagnosemagnetfeldsignaleliminierende Differenzbildung zwischen den Messsignalen der Magnetfeldsensoren einer jeden Messung, der Messbetrieb des differentiellen Magnetfeldmesssystems unterbrechungsfrei und parallel zur Diagnose erfolgen. Ferner kann durch die Verwendung der Magnetfeldsensor-Diagnoseeinheit 10 und durch das voranstehend beschriebene Verfahren, umfassend das magnetfeldsensorzugehörige Bilden von Differenzen zwischen aufeinanderfolgenden Messsignal-Messungen während zumindest zwei verschiedenen Diagnosestromhöhen und auf diesen basierend das Detektieren von Fehlfunktionen der Magnetfeldsensoren, der differentielle Messbetrieb parallel zur Funktionsdiagnose nicht nur ununterbrochen, sondern darüber hinaus auch ungestört und fehlerfrei bleiben, insbesondere bei Drifts des Diagnosestroms während dem Messbetrieb beispielsweise über Temperatur, wofür keine kostenerhöhende messtechnische Erfassung der erzeugten Diagnoseströme erforderlich ist.

Figur 11 zeigt ein Flussdiagramm zur Illustration von Schritten des Verfahrens 100 wie voranstehend und nachfolgend beschrieben. Dabei weist das Verfahren insbesondere die Schritte S1 bis S6 auf, wie diese in Bezug auf Figur 10 erläutert wurden.

Weiter bevorzugt umfasst das Verfahren 100 den Schritt S7 Bilden eines vom ersten Diagnosemagnetfeldsignal bereinigten differentiellen Messmagnetfeldsignals als ersten Wert der Messgröße des Magnetfeldmesssystems durch Differenzbildung zwischen dem ersten Messsignal des ersten Magnetfeldsensors 20 und dem ersten Messsignal des zweiten Magnetfeldsensors 26 der ersten Messung. Vorzugsweise umfasst das Verfahren 100 den Schritt S8 Bilden eines vom zweiten Diagnosemagnetfeldsignal bereinigten differentiellen Messmagnetfeldsignals als Folgewert der Messgröße des Magnetfeldmesssystems durch Differenzbildung zwischen dem zweiten Messsignal des ersten Magnetfeldsensors 20 und dem zweiten Messsignal des zweiten Magnetfeldsensors 26 der zweiten Messung.

Weiter bevorzugt umfasst das Verfahren 100 den Schritt Vergleichen S10 der ersten Differenz und der zweiten Differenz mit zumindest einem vorbestimmten Schwellwert, um die Eigenschaft des ersten Magnetfeldsensors 20 und/oder des zweiten Magnetfeldsensors 26 zu ermitteln. Bevorzugt umfasst das Verfahren 100 das Ermitteln und/oder Empfangen S11 einer Kalibrierung eines Diagnosemagnetfelds des ersten Magnetfeldsensors 20 und/oder des zweiten Magnetfeldsensors 26. Vorzugsweise umfasst das Verfahren 100 den Schritt S12 Vergleichen der ersten Differenz und der zweiten Differenz mit zumindest einem vorbestimmten Schwellwert basierend auf der Kalibrierung des Diagnosemagnetfelds des ersten Magnetfeldsensors 20 und/oder des zweiten Magnetfeldsensors 26, um die Eigenschaft des ersten Magnetfeldsensors 20 und/oder des zweiten Magnetfeldsensors 26 zu ermitteln. Das Verfahren 100 umfasst somit beispielhaft und in anderen Worten bevorzugt das Detektieren von Fehlfunktionen der Magnetfeldsensoren unter der zusätzlichen Berücksichtigung einer vorab ermittelten Kalibrierung des differentiellen Diagnosemagnetfelds, auftretend in den Magnetfeldsensoren, zugehörig zu dem differentiellen Soll-Diagnosestrom basierend auf zumindest zwei Werten mit den Vorteilen, dass etwaige Abweichungen der Diagnosestromsignale durch Toleranzen beispielsweise des Stromtreibers berücksichtigt werden können, dass die Detektionsgenauigkeit durch mögliche engere Grenzwerte erhöht werden kann und dass ein Drift des Diagnosestroms beispielsweise über Temperatur nicht nur in dem differentiellen Messmagnetfeldsignal als Messgröße des differentiellen Magnetfeldmesssystems eliminiert wird sondern die Toleranz, bzw. die Robustheit gegenüber Diagnosestromdrifts auch für die Funktionsdiagnose weiter erhöht werden kann.

Weiter bevorzugt umfasst das Verfahren 100 den Schritt Erfassen S19 des ersten Messsignals mittels der ersten Messung durch einen dritten Magnetfeldsensor 34 mit einer dritten Messachse 36, wobei die erste Messachse 22, die zweite Messachse 28 und die dritte Messachse 36 die im Wesentlichen gleiche Ausrichtung bzw. die im Wesentlichen gleiche relative Lage 30 aufweisen. Vorzugsweise umfasst das Verfahren 100 die Schritte Erfassen S20 des zweiten Messsignals mittels der zweiten Messung durch den dritten Magnetfeldsensor 34, Bilden S22 einer dritten Differenz zwischen dem zweiten Messsignal und dem ersten Messsignal des dritten Magnetfeldsensors 34 und Ermitteln S23 zumindest einer Eigenschaft des ersten Magnetfeldsensors 20, des zweiten Magnetfeldsensors 26 und/oder des dritten Magnetfeldsensors 34 basierend auf einem Vergleich der ersten Differenz, der zweiten Differenz und/oder der dritten Differenz.

Weiter bevorzugt umfasst das Verfahren 100 die Schritte Bilden S13 einer ersten Vergleichsdifferenz zwischen der ersten Differenz und der zweiten Differenz und Vergleichen S14 der ersten Vergleichsdifferenz mit zumindest einem vorbestimmten Grenzwert, um einen ersten Zustand zu ermitteln. Vorzugsweise umfasst das Verfahren 100 die Schritte Bilden S26 einer zweiten Vergleichsdifferenz zwischen der zweiten Differenz und der dritten Differenz und Vergleichen S27 der zweiten Vergleichsdifferenz mit den vorbestimmten Grenzwerten, um einen zweiten Zustand zu ermitteln. Bevorzugt umfasst das Verfahren 100 den Schritt Detektieren S28 einer Störung des ersten Magnetfeldsensors 20, wenn der erste Zustand vorliegt, einer Störung des zweiten Magnetfeldsensors 26, wenn der erste Zustand und der zweite Zustand vorliegen, und/oder einer Störung des dritten Magnetfeldsensors 34, wenn der zweite Zustand vorliegt.

Das Verfahren 100 umfasst somit beispielhaft und in anderen Worten bevorzugt das Detektieren von Fehlfunktionen der Magnetfeldsensoren ohne eine vorab ermittelte Kalibrierung jedoch unter der Berücksichtigung einer differentiellen Auswertung zwischen den Magnetfeldsensoren mittels Vergleichsdifferenzen, gebildet zwischen den, zu dem basierend auf zwei Werten differentiellen Diagnosestrom zugehörigen, magnetfeldsensorzugehörigen Differenzen mit den Vorteilen, dass etwaige Abweichungen der Diagnosestromsignale durch Toleranzen beispielsweise des Stromtreibers in der Vergleichsdifferenz eliminiert werden können, dass die Detektionsgenauigkeit durch mögliche engere Grenzwerte erhöht werden kann, dass der Drift des Diagnosestroms beispielsweise über Temperatur auch in der Funktionsdiagnose eliminiert werden kann während lediglich ergänzend absolut auf ein Mindestdiagnosemagnetfeld geprüft werden kann und dass zudem etwaige überlagerte hochdynamische Wechselstörfelder auch vor der Funktionsdiagnose eliminiert werden können.

Weiter bevorzugt umfasst das Verfahren 100 für das Bilden S13 der ersten Vergleichsdifferenz die Schritte Bereinigen S30 der ersten Differenz mit einer ersten Kalibrierung des Diagnosemagnetfelds des ersten Magnetfeldsensors 20 und Bereinigen S31 der zweiten Differenz mit einer zweiten Kalibrierung des Diagnosemagnetfelds des zweiten Magnetfeldsensors 26. Vorzugsweise umfasst das Verfahren 100 für das Bilden S26 der zweiten Vergleichsdifferenz die Schritte Bereinigen S32 der zweiten Differenz mit einer zweiten Kalibrierung des Diagnosemagnetfelds des zweiten Magnetfeldsensors 26 und Bereinigen S33 der dritten Differenz mit einer dritten Kalibrierung des Diagnosemagnetfelds des dritten Magnetfeldsensors 34. Das Verfahren 100 umfasst somit beispielhaft und in anderen Worten bevorzugt das Detektieren von Fehlfunktionen der Magnetfeldsensoren unter der Berücksichtigung einer differentiellen Auswertung zwischen den Magnetfeldsensoren mittels den Vergleichsdifferenzen und unter zusätzlicher Berücksichtigung einer Bereinigung der für die Bildung der Vergleichsdifferenzen verwendeten Differenzen mittels vorab ermittelten Kalibrierungen der differentiellen Diagnosemagnetfelder, auftretend in den Magnetfeldsensoren, zugehörig zu dem differentiellen Soll-Diagnosestrom basierend auf zwei Werten mit dem weiteren Vorteil gegenüber der Ausführung ohne Kalibrierung, dass etwaig verbliebene Resttoleranzen aus der Fertigung der Magnetfeldsensoren und der Fertigung/Montage der Magnetfeldsensor-Diagnoseeinheit mit den Magnetfeldsensoren eliminiert werden können.

Weiter bevorzugt umfasst das Verfahren 100 die Schritte Vergleichen S16 eines ersten Betrags der ersten Differenz mit einem Minimalwert, Vergleichen S17 eines zweiten Betrags der zweiten Differenz mit dem Minimalwert, und/oder Vergleichen S15 eines dritten Betrags der dritten Differenz mit dem Minimalwert und Ausgeben S18 eines Warnsignals, wenn der erste Betrag, der zweite Betrag und/oder der dritte Betrag den Minimalwert unterschreitet.

Das Verfahren 100 umfasst somit beispielhaft und in anderen Worten bevorzugt das Detektieren von Fehlfunktionen der Magnetfeldsensoren mit oder ohne eine vorab ermittelte Kalibrierung und unter der Berücksichtigung einer differentiellen Auswertung zwischen den Magnetfeldsensoren mittels Vergleichsdifferenzen, sowie unter der ergänzenden Berücksichtigung einer absoluten Auswertung mittels den Beträgen der Differenzen, sodass sich eine hybride Auswertung ergibt mit den Vorteilen, dass die Detektionsgenauigkeit durch mögliche enge Grenzwerte für die differentielle Auswertung erhöht wird und damit die absolute Auswertung mit einfacher Aufgabe der Überwachung auf ausreichende Änderungen des Diagnosesignals mit weiten Grenzwerten bzw. einem Minimalwert als Grenzwert versehen werden kann, sodass sogar etwaige überlagerte hochdynamische Wechselstörfelder die Funktionsdiagnose in ihrer Funktion nicht beeinträchtigen.

Weiter bevorzugt umfasst das Verfahren 100 die Schritte Erzeugen S34 eines dritten Signals mit dem ersten Wert in den Signalleiter 14, Erfassen S35 jeweils eines dritten Messsignals mittels einer dritten Messung durch den ersten Magnetfeldsensor 20, durch den zweiten Magnetfeldsensor 26 und durch den dritten Magnetfeldsensor 34, Bilden S36 jeweils einer ersten Differenzvariablen zwischen dem erfassten zweiten Messsignal und dem erfassten ersten Messsignal für den ersten Magnetfeldsensor 20, den zweiten Magnetfeldsensor 26, und den dritten Magnetfeldsensor 34, Bilden S37 jeweils einer zweiten Differenzvariablen zwischen dem erfassten zweiten Messsignal und dem erfassten dritten Messsignal für den ersten Magnetfeldsensor 20, den zweiten Magnetfeldsensor 26, und den dritten Magnetfeldsensor 34, Bilden S38 jeweils eines Differenzvariablenmittelwerts basierend auf einem Differenzvergleich zwischen der ersten Differenzvariablen und der zweiten Differenzvariablen für den ersten Magnetfeldsensor 20, den zweiten Magnetfeldsensor 26, und den dritten Magnetfeldsensor 34 und Ersetzen S39 eines Werts der ersten Differenz, der zweiten Differenz und der dritten Differenz jeweils mit dem Differenzvariablenmittelwert des ersten Magnetfeldsensors 20, des zweiten Magnetfeldsensors 26 und des dritten Magnetfeldsensors 34.

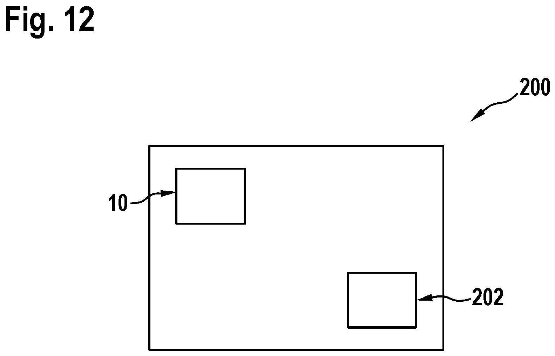

Figur 12 zeigt ein Fahrzeug 200, insbesondere ein elektrisch angetriebenes Fahrrad, aufweisend eine Magnetfeldsensor-Diagnoseeinheit 10, umfassend einen Signaltreiber 12 (in Figur 12 nicht dargestellt, vgl. Figur 1) und eine Logikeinheit 16 (in Figur 12 nicht dargestellt, vgl. Figur 1), sowie eine Steuereinheit 202, welche dazu eingerichtet ist, das Verfahren 100, wie voranstehend beschrieben, auszuführen.

## Patentansprüche

1. Verfahren (100) zur, insbesondere messbetriebsunterbrechungsfreien und diagnosestromdrifttoleranten, Funktionsdiagnose und/oder Fehlerdiagnose von Magnetfeldsensoren in einem differentiellen Magnetfeldmesssystem mittels einer Magnetfeldsensor-Diagnoseeinheit (10), aufweisend die Schritte:
- Erzeugen (S1) eines ersten Signals mit einem ersten Wert in einen Signalleiter (14),
- Erfassen (S2) jeweils eines ersten Messsignals mittels einer ersten Messung durch einen ersten Magnetfeldsensor (20) mit einer ersten Messachse (22) und durch einen zweiten Magnetfeldsensor (26) mit einer zweiten Messachse (28), wobei die erste Messachse (22) und die zweite Messachse (28) im Wesentlichen eine gleiche relative Lage (30) aufweisen,
- Erzeugen (S3) eines zweiten Signals mit einem zweiten Wert in den Signalleiter (14),
- Erfassen (S4) jeweils eines zweiten Messsignals mittels einer zweiten Messung durch den ersten Magnetfeldsensor (20) und durch den zweiten Magnetfeldsensor (26),
- Bilden (S5) einer ersten Differenz zwischen dem zweiten Messsignal und dem ersten Messsignal des ersten Magnetfeldsensors (20) und Bilden (S9) einer zweiten Differenz zwischen dem zweiten Messsignal und dem ersten Messsignal des zweiten Magnetfeldsensors (26),
- Ermitteln (S6) der zumindest einen Eigenschaft des ersten Magnetfeldsensors (20) und/oder des zweiten Magnetfeldsensors (26) basierend auf der ersten Differenz und der zweiten Differenz.

2. Verfahren gemäß Anspruch 1, ferner aufweisend die Schritte:
- Bilden (S7) eines ersten von einem ersten Diagnosemagnetfeldsignal bereinigten differentiellen Messmagnetfeldsignals als ersten Wert der Messgröße des Magnetfeldmesssystems durch Differenzbildung zwischen dem ersten Messsignal des ersten Magnetfeldsensors (20) der ersten Messung und dem ersten Messsignal des zweiten Magnetfeldsensors (26) der ersten Messung
- Bilden (S8) eines weiteren von einem zweiten Diagnosemagnetfeldsignal bereinigten differentiellen Messmagnetfeldsignals als Folgewert der Messgröße des Magnetfeldmesssystems durch Differenzbildung zwischen dem zweiten Messsignal des ersten Magnetfeldsensors (20) der zweiten Messung und dem zweiten Messsignal des zweiten Magnetfeldsensors (26) der zweiten Messung.

3. Verfahren gemäß Anspruch 1 oder 2, wobei das Ermitteln der zumindest einen Eigenschaft den Schritt umfasst:
- Vergleichen (S10) der ersten Differenz und der zweiten Differenz mit zumindest einem vorbestimmten Schwellwert, um die Eigenschaft des ersten Magnetfeldsensors (20) und/oder des zweiten Magnetfeldsensors (26) zu ermitteln.

4. Verfahren gemäß einem der vorherigen Ansprüche, wobei das Ermitteln der zumindest einen Eigenschaft die Schritte aufweist:
- Ermitteln und/oder Empfangen (S11) einer Kalibrierung eines Diagnosemagnetfelds des ersten Magnetfeldsensors (20) und/oder des zweiten Magnetfeldsensors (26),
- Vergleichen (S12) der ersten Differenz und der zweiten Differenz mit zumindest einem vorbestimmten Schwellwert basierend auf der Kalibrierung des Diagnosemagnetfelds des ersten Magnetfeldsensors (20) und/oder des zweiten Magnetfeldsensors (26), um die Eigenschaft des ersten Magnetfeldsensors (20) und/oder des zweiten Magnetfeldsensors (26) zu ermitteln.

5. Verfahren gemäß einem der vorherigen Ansprüche, ferner umfassend die Schritte:
- Erfassen (S19) des ersten Messsignals mittels der ersten Messung durch einen dritten Magnetfeldsensor (34) mit einer dritten Messachse (36), wobei die erste Messachse (22), die zweite Messachse (28) und die dritte Messachse (36) im Wesentlichen die gleiche relative Lage (30) aufweisen,
- Erfassen (S20) des zweiten Messsignals mittels der zweiten Messung durch den dritten Magnetfeldsensor (34),
- Bilden (S22) einer dritten Differenz zwischen dem zweiten Messsignal und dem ersten Messsignal des dritten Magnetfeldsensors (34),
- Ermitteln (S23) zumindest einer Eigenschaft des ersten Magnetfeldsensors (20), des zweiten Magnetfeldsensors (26) und/oder des dritten Magnetfeldsensors (34) basierend auf einem Vergleich der ersten Differenz, der zweiten Differenz und/oder der dritten Differenz.

6. Verfahren gemäß einem der vorhergehenden Ansprüche, wobei das Ermitteln der zumindest einen Eigenschaft ferner die Schritte aufweist:
- Bilden (S13) einer ersten Vergleichsdifferenz zwischen der ersten Differenz und der zweiten Differenz,
- Vergleichen (S14) der ersten Vergleichsdifferenz mit zumindest einem vorbestimmten Grenzwert, um einen ersten Zustand zu ermitteln,
- Bilden (S26) einer zweiten Vergleichsdifferenz zwischen der zweiten Differenz und der dritten Differenz,
- Vergleichen (S27) der zweiten Vergleichsdifferenz mit zumindest einem weiteren vorbestimmten Grenzwert, um einen zweiten Zustand zu ermitteln,
- Detektieren (S28) einer Eigenschaft, insbesondere einer Fehlfunktion, des ersten Magnetfeldsensors (20), wenn der erste Zustand vorliegt, einer Eigenschaft, insbesondere Fehlfunktion, des zweiten Magnetfeldsensors (26), wenn der erste Zustand und der zweite Zustand vorliegen, und/oder einer Eigenschaft, insbesondere Fehlfunktion, des dritten Magnetfeldsensors (34), wenn der zweite Zustand vorliegt.

7. Verfahren gemäß Anspruch 6, wobei das Bilden (S13) der ersten Vergleichsdifferenz ferner die Schritte aufweist:
- Bereinigen (S30) der ersten Differenz mit einer ersten Kalibrierung des Diagnosemagnetfelds des ersten Magnetfeldsensors (20),
- Bereinigen (S31) der zweiten Differenz mit einer zweiten Kalibrierung des Diagnosemagnetfelds des zweiten Magnetfeldsensors (26),
und wobei das Bilden (S26) der zweiten Vergleichsdifferenz ferner die Schritte umfasst:
- Bereinigen (S32) der zweiten Differenz mit einer zweiten Kalibrierung des Diagnosemagnetfelds des zweiten Magnetfeldsensors (26),
- Bereinigen (S33) der dritten Differenz mit einer dritten Kalibrierung des Diagnosemagnetfelds des dritten Magnetfeldsensors (34).

8. Verfahren gemäß einem der vorherigen Ansprüche, ferner umfassend die Schritte:
- Vergleichen (S16) eines ersten Betrags der ersten Differenz mit einem Minimalwert,
- Vergleichen (S17) eines zweiten Betrags der zweiten Differenz mit dem Minimalwert, und/oder
- Vergleichen (S15) eines dritten Betrags der dritten Differenz mit dem Minimalwert,
- Ausgeben (S18) eines Warnsignals, wenn der erste Betrag, der zweite Betrag und/oder der dritte Betrag den Minimalwert unterschreitet.

9. Verfahren gemäß einem der vorhergehenden Ansprüche, wobei das Verfahren ferner die Schritte aufweist:
- Erzeugen (S34) eines dritten Signals mit dem ersten Wert in den Signalleiter (14),
- Erfassen (S35) jeweils eines dritten Messsignals mittels einer dritten Messung durch den ersten Magnetfeldsensor (20), durch den zweiten Magnetfeldsensor (26) und durch den dritten Magnetfeldsensor (34),
- Bilden (S36) jeweils einer ersten Differenzvariablen zwischen dem zweiten Messsignal und dem ersten Messsignal für den ersten Magnetfeldsensor (20), den zweiten Magnetfeldsensor (26), und den dritten Magnetfeldsensor (34),
- Bilden (S37) jeweils einer zweiten Differenzvariablen zwischen dem zweiten Messsignal und dem dritten Messsignal für den ersten Magnetfeldsensor (20), den zweiten Magnetfeldsensor (26), und den dritten Magnetfeldsensor (34),
- Bilden (S38) jeweils eines Differenzvariablenmittelwerts basierend auf einem Differenzvergleich zwischen der ersten Differenzvariablen und der zweiten Differenzvariablen für den ersten Magnetfeldsensor (20), den zweiten Magnetfeldsensor (26), und den dritten Magnetfeldsensor (34),
- Ersetzen (S39) eines Werts der ersten Differenz, der zweiten Differenz und der dritten Differenz jeweils mit dem Differenzvariablenmittelwert des ersten Magnetfeldsensors (20), des zweiten Magnetfeldsensors (26) und des dritten Magnetfeldsensors (34).

10. Magnetfeldsensor-Diagnoseeinheit (10) zur messbetriebsunterbrechungsfreien und diagnosestromdrifttoleranten Funktionsdiagnose von Magnetfeldsensoren in einem differentiellen Magnetfeldmesssystem, aufweisend:
einen Signaltreiber (12),
einen Signalleiter (14) und
eine Logikeinheit (16), welche dazu eingerichtet ist, eine Signalfolge mit zumindest zwei unterschiedlichen Werten mittels des Signaltreibers (12) zu erzeugen,
wobei der Signaltreiber (12) dazu eingerichtet ist, die Signalfolge in den Signalleiter (14) zu leiten,
wobei der Signalleiter (14) eine erste Orientierung (18) und eine erste Distanz (19) zu einem ersten Magnetfeldsensor (20) mit einer ersten Messachse (22) aufweist,
wobei der Signalleiter (14) eine zweite Orientierung (24) und eine zweite Distanz (25) zu einem zweiten Magnetfeldsensor (26) mit einer zweiten Messachse (28) aufweist,
wobei die erste Messachse (22) und die zweite Messachse (28) eine im Wesentlichen gleiche relative Lage (30) aufweisen,
wobei die erste Orientierung (18) und die erste Distanz (19) und die zweite Orientierung (24) und die zweite Distanz (25) im Wesentlichen gleich sind, und
wobei die Logikeinheit (16) dazu eingerichtet ist, die Signalfolge mittels des ersten Magnetfeldsensors (20) und des zweiten Magnetfeldsensors (26) zu erfassen, um zumindest eine Eigenschaft des ersten Magnetfeldsensors (20) und/oder des zweiten Magnetfeldsensors (26) zu ermitteln.

11. Magnetfeldsensor-Diagnoseeinheit (10) nach Anspruch 10, wobei der Signalleiter (14) eine dritte Orientierung (32) und eine dritte Distanz (33) zu einem dritten Magnetfeldsensor (34) mit einer dritten Messachse (36) aufweist, wobei die erste Messachse (22), die zweite Messachse (28) und die dritte Messachse (36) die im Wesentlichen gleiche relative Lage (30) aufweisen, wobei die erste Orientierung (18) und die erste Distanz (19), die zweite Orientierung (24) und die zweite Distanz (25) und die dritte Orientierung (32) und die dritte Distanz (33) im Wesentlichen gleich sind,
wobei die Logikeinheit (16) dazu eingerichtet ist, die Signalfolge mittels des ersten Magnetfeldsensors (20), des zweiten Magnetfeldsensors (26) und des dritten Magnetfeldsensors (34) zu erfassen, um zumindest eine Eigenschaft des ersten Magnetfeldsensors (20), des zweiten Magnetfeldsensors (26) und/oder des dritten Magnetfeldsensors (34) zu ermitteln.

12. Magnetfeldsensor-Diagnoseeinheit (10) nach einem der Ansprüche 10 oder 11, wobei die Logikeinheit (16) zumindest ein Speicherelement (38) aufweist, wobei das Speicherelement (38) dazu eingerichtet ist, zumindest eine Kalibrierung zumindest eines Diagnosemagnetfelds zumindest des ersten Magnetfeldsensors (20), des zweiten Magnetfeldsensors (26) und/oder des dritten Magnetfeldsensors (34) zu speichern,
wobei die Logikeinheit (16) dazu eingerichtet ist, mittels der zumindest einen Kalibrierung die Bestimmung der zumindest einen Eigenschaft des zumindest einen Magnetfeldsensors anzupassen.

13. Magnetfeldsensor-Diagnoseeinheit (10) nach einem der Ansprüche 10 bis 12, wobei die erste Orientierung (18) einen ersten Teilabschnitt (40) des Signalleiters (14) umfasst, wobei die zweite Orientierung (24) einen zweiten Teilabschnitt (42) des Signalleiters (14) umfasst, wobei der Signalleiter (14) einen fünften Teilabschnitt (45) umfasst, welcher eine fünfte Orientierung aufweist, wobei die fünfte Orientierung (44) im Wesentlichen entgegengesetzt zu der ersten Orientierung (18) und der zweiten Orientierung (24) ausgerichtet ist, wobei der fünfte Teilabschnitt (45) des Signalleiters (14) zwischen dem ersten Teilabschnitt (40) des Signalleiters (14) und dem zweiten Teilabschnitt (42) des Signalleiters (14) angeordnet ist, wobei der erste Teilabschnitt (40) des Signalleiters (14), der zweite Teilabschnitt (42) des Signalleiters (14) und der fünfte Teilabschnitt (45) des Signalleiters (14) im Wesentlichen äquidistant zueinander angeordnet sind.

14. Magnetfeldsensor-Diagnoseeinheit (10) nach einem der Ansprüche 10 bis 13, wobei der Signalleiter (14) anhand eines vorbestimmten Musters (46) zum ersten Magnetfeldsensor (20) und zum zweiten Magnetfeldsensor (26) angeordnet ist.

15. Magnetfeldsensor-Diagnoseeinheit (10) nach Anspruch 14, wobei der Signalleiter (14) anhand des vorbestimmten Musters (46) zum ersten Magnetfeldsensor (20), zum zweiten Magnetfeldsensor (26) und zum dritten Magnetfeldsensor (34) angeordnet ist.

16. Antriebseinheit für ein Fahrzeug (200), insbesondere ein elektrisch angetriebenes Fahrrad, mit einer Magnetfeldsensor-Diagnoseeinheit (10) gemäß einem der Ansprüche 10 bis 15 und/oder einer Steuereinheit (202) welche dazu eingerichtet ist, ein Verfahren gemäß einem der Ansprüche 1 bis 9 auszuführen.

17. Verwendung einer Magnetfeldsensor-Diagnoseeinheit (10) gemäß einem der Ansprüche 10 bis 15 zur messbetriebsunterbrechungsfreien und diagnosestromdrifttoleranten Funktionsdiagnose von Magnetfeldsensoren in einem differentiellen Magnetfeldmesssystem.
